# EUROPEAN PATENT APPLICATION

(11) **EP 4 676 206 A1**
(43) Date of publication of application: **07.01.2026**
(21) Application number: 25187238.8
(22) Date of filing: 03.07.2025
(51) Int. Cl.: H10K 59/131, H10K 59/40, H10K 59/80, H10K 71/00

(54) **DISPLAY APPARATUS, METHOD OF MANUFACTURING DISPLAY APPARATUS, AND ELECTRONIC APPARATUS INCLUDING DISPLAY APPARATUS**

(30) Priority: 05.07.2024 KR 20240089185
(71) Applicant: Samsung Display Co., Ltd., Yongin-si, Gyeonggi-do 17113 (KR)
(72) Inventor: KWON, Ohjune, 17113 Yongin-si (KR); SUNG, Wooyong, 17113 Yongin-si (KR)
(74) Representative: Marks & Clerk LLP

(57) **Abstract**

A display apparatus includes a substrate including a display area, and a peripheral area outside the display area, a dam portion disposed in the peripheral area, a crack dam disposed between the dam portion and an edge of the substrate, an organic planarization layer disposed in the display area and the peripheral area to cover a display element, the dam portion, and the crack dam, a metal layer disposed between the organic planarization layer and the crack dam and extending in a direction from the crack dam to the edge of the substrate, and an inorganic protective layer disposed between the organic planarization layer and the metal layer and covering a portion of the metal layer. A portion of a part of the organic planarization layer disposed between the crack dam and the edge of the substrate is in direct contact with the metal layer.

## Description

### BACKGROUND

### 1. Field

Embodiments relate to a display apparatus, a method of manufacturing a display apparatus, and an electronic apparatus, and more particularly, to a display apparatus, a method of manufacturing a display apparatus, and an electronic apparatus, with a reduced possibility of defect occurrence during a manufacturing process.

### 2. Description of the Related Art

To support various functions, an electronic apparatus includes a display apparatus that may provide a user with visual information such as images. A display apparatus may be formed by coupling various members to each other. Specifically, a display apparatus may be formed by coupling a display panel including light-emitting elements to a cover window protecting the display panel. An organic planarization layer may be disposed between the display panel and the cover window to planarize a step difference in the lower portion and allow the cover window to be easily attached to the display panel.

A plurality of display apparatuses is simultaneously manufactured by simultaneously forming a plurality of display parts on one mother board, and then cutting the mother board along the edges of each of the display parts.

### SUMMARY

However, in display apparatuses according to the related art, an organic planarization layer is easily detached from a display panel by external impacts or the like.

Embodiments include a display apparatus with a reduced possibility of defect occurrence during a manufacturing process, and a method of manufacturing a display apparatus, and an electronic apparatus. However, such a technical problem is just an example, and the disclosure is not limited thereto.

Additional features will be set forth in part in the description which follows and, in part, will be apparent from the description, or may be learned by practice of the presented embodiments of the disclosure.

In an embodiment of the disclosure, a display apparatus includes a substrate including a display area in which a display element is disposed, and a peripheral area outside the display area, a dam portion disposed in the peripheral area to surround the display area, a crack dam disposed between the dam portion and an edge of the substrate, an organic planarization layer disposed in the display area and the peripheral area to cover the display element, the dam portion, and the crack dam, a metal layer disposed between the organic planarization layer and the crack dam and extending in a direction from the crack dam to the edge of the substrate, and an inorganic protective layer disposed between the organic planarization layer and the metal layer and covering a portion of the metal layer, and a portion of a part of the organic planarization layer disposed between the crack dam and the edge of the substrate is in direct contact with the metal layer.

In an embodiment, the display apparatus may further include an inorganic insulating layer covering the display element, the dam portion, and the crack dam, and the metal layer may be disposed on the inorganic insulating layer.

In an embodiment, the inorganic protective layer may be disposed on the metal layer to be spaced apart from the edge of the substrate.

In an embodiment, an end of the inorganic protective layer may be disposed on the metal layer.

In an embodiment, the metal layer may extend in a direction from the crack dam to the dam portion, the inorganic protective layer may include a first inorganic protective layer and a second inorganic protective layer apart from each other, the first inorganic protective layer may cover a portion of the metal layer disposed on the dam portion, the second inorganic protective layer may cover a portion of the metal layer disposed on the crack dam, and the second inorganic protective layer may partially cover a portion of the metal layer disposed between the crack dam and the edge of the substrate.

In an embodiment, the inorganic protective layer may not cover a portion of a part of the metal layer disposed between the dam portion and the crack dam.

In an embodiment, a portion of a part of the organic planarization layer disposed between the dam portion and the crack dam may be in direct contact with the metal layer.

In an embodiment, the metal layer may include a first metal layer, a second metal layer, and a third metal layer disposed between the first metal layer and the second metal layer, the first metal layer may cover a portion of the inorganic insulating layer disposed on the dam portion, the second metal layer may cover a portion of the inorganic insulating layer disposed between the crack dam and the edge of the substrate, the first inorganic protective layer may cover the first metal layer, and the second inorganic protective layer may cover the second metal layer.

In an embodiment, the inorganic protective layer may be partially disposed on a portion of the metal layer disposed between the crack dam and the edge of the substrate.

In an embodiment, an end of the inorganic protective layer may be disposed on a portion of the metal layer disposed between the crack dam and the edge of the substrate.

In an embodiment, the inorganic protective layer may cover a portion of the metal layer next (adjacent) to the crack dam and may not cover a portion of the metal layer next (adjacent) to the edge of the substrate.

In an embodiment, the metal layer may be partially disposed on a portion of the inorganic insulating layer disposed between the crack dam and the edge of the substrate.

In an embodiment, an end of the metal layer may be disposed on a portion of the inorganic insulating layer disposed between the crack dam and the edge of the substrate.

In an embodiment, the metal layer may cover a portion of the inorganic insulating layer next (adjacent) to the crack dam and may not cover a portion of the inorganic insulating layer next (adjacent) to the edge of the substrate.

In an embodiment, the organic planarization layer may cover an end of the metal layer.

In an embodiment, the display apparatus may further include an encapsulation layer disposed in the display area and the peripheral area to seal the display element, and a touch sensor layer disposed on the encapsulation layer and including a touch conductive layer and a touch insulating layer covering the touch conductive layer.

In an embodiment, the metal layer may include a same material as a material of the touch conductive layer, and the inorganic protective layer may include a same material as a material of the touch insulating layer.

In an embodiment of the disclosure, a method of manufacturing a display apparatus includes preparing a mother board including a panel area and a margin area, wherein the panel area includes a display area and a peripheral area outside the display area, and the margin area surrounds the panel area entirely, forming a display element in the display area, forming a dam portion in the peripheral area to be next (adjacent) to the display area, and forming a crack dam in the peripheral area to be next (adjacent) to the margin area, forming an inorganic insulating layer over the display area and the peripheral area to cover the display element, the dam portion, and the crack dam, forming a metal layer on the inorganic insulating layer, the metal layer covering the crack dam and extending in a direction from the crack dam to a panel border, which is a border between the panel area and the margin area, forming an inorganic protective layer on the metal layer to cover a portion of the metal layer, forming an organic planarization layer over the display area and the peripheral area to cover the inorganic protective layer, and cutting the mother board along the panel border. The forming the organic planarization layer includes forming the organic planarization layer such that a portion of a part of the organic planarization layer formed between the crack dam and the panel border is in direct contact with the metal layer.

In an embodiment, the forming the inorganic protective layer may include forming the inorganic protective layer such that the inorganic protective layer is spaced apart from the panel border and an end of the inorganic protective layer is disposed on the metal layer.

In an embodiment, the forming the inorganic insulating layer may include forming a margin inorganic insulating layer in the margin area, the forming the metal layer may include forming a margin metal layer on the margin inorganic insulating layer, and the forming the organic planarization layer may include forming a margin organic planarization layer on the margin metal layer. In the cutting the mother board, the margin inorganic insulating layer, the margin metal layer, and the margin organic planarization layer may be removed.

In an embodiment, the forming the metal layer may include forming a touch conductive layer on the inorganic insulating layer in the display area, and the forming the inorganic protective layer may include forming a touch insulating layer covering the touch conductive layer.

In embodiments, an electronic apparatus includes a display apparatus, and a housing accommodating the display apparatus and forming an exterior. The display apparatus includes a substrate including a display area in which a display element is disposed, and a peripheral area outside the display area, a dam portion disposed in the peripheral area to surround the display area, a crack dam disposed between the dam portion and an edge of the substrate, an organic planarization layer disposed in the display area and the peripheral area to cover the display element, the dam portion, and the crack dam, a metal layer disposed between the organic planarization layer and the crack dam and extending in a direction from the crack dam to the edge of the substrate, and an inorganic protective layer disposed between the organic planarization layer and the metal layer and covering a portion of the metal layer, wherein a portion of a part of the organic planarization layer disposed between the crack dam and the edge of the substrate is in direct contact with the metal layer.

At least some of the above and other features of the invention are set out in the claims.

These and/or other features will become apparent and more readily appreciated from the following detailed description of the embodiments, the accompanying drawings, and claims.

### BRIEF DESCRIPTION OF THE DRAWINGS

The above and other features and advantages of illustrative embodiments of the disclosure will be more apparent from the following description taken in conjunction with the accompanying drawings, in which:
FIG. 1A is a schematic perspective view of an embodiment of an electronic apparatus;
FIG. 1B is a schematic plan view of an embodiment of a display apparatus;
FIG. 2 is a schematic side view of an embodiment of a display apparatus;
FIG. 3 is a schematic plan view of a portion of a touch sensor layer of FIG. 2;
FIG. 4 is an enlarged plan view of a region A of FIG. 3;
FIG. 5 is an equivalent circuit diagram of a pixel included in the display apparatus of FIG. 1B;
FIG. 6 is a schematic cross-sectional view of the display apparatus of FIG. 1B, taken along lines I-I' and II-II' of FIG. 1B;
FIG. 7 is a schematic plan view of an embodiment of a display apparatus;
FIG. 8 is a schematic cross-sectional view of an embodiment of a display apparatus;
FIG. 9 is a schematic cross-sectional view of an embodiment of a display apparatus;
FIG. 10 is a schematic cross-sectional view of an embodiment of a display apparatus; and
FIGS. 11 to 17 are schematic views showing a portion of a process of manufacturing the display apparatus of FIG. 6.

### DETAILED DESCRIPTION

Reference will now be made in detail to embodiments, embodiments of which are illustrated in the accompanying drawings, wherein like reference numerals refer to like elements throughout. In this regard, the illustrated embodiments may have different forms and should not be construed as being limited to the descriptions set forth herein. Accordingly, the embodiments are merely described below, by referring to the drawing figures, to explain features of the description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the disclosure allows for various changes and numerous embodiments, illustrative embodiments will be illustrated in the drawings and described in the written description. Effects and features of the disclosure, and methods for achieving them will be clarified with reference to embodiments described below in detail with reference to the drawings. However, the disclosure is not limited to the following embodiments and may be embodied in various forms.

While such terms as "first" and "second" may be used to describe various components, such components must not be limited to the above terms. The above terms are used to distinguish one component from another.

The singular forms "a," "an," and "the" as used herein are intended to include the plural forms as well unless the context clearly indicates otherwise.

It will be understood that the terms "comprise," "comprising," "include" and/or "including" as used herein specify the presence of stated features or components but do not preclude the addition of one or more other features or components.

In the specification, "A and/or B" means A or B, or A and B. In the specification, "at least one of A and B" means A or B, or A and B.

In the specification, when various elements such as a layer, a region, a plate, and the like are disposed "on" another element, not only the elements may be disposed "directly on" the other element, but another element may be disposed therebetween.

It will be understood that when a layer, region, or component is referred to as being "connected" to another layer, region, or component, it may be "directly connected" to the other layer, region, or component or may be "indirectly connected" to the other layer, region, or component with other layer, region, or component interposed therebetween. For example, it will be understood that when a layer, region, or element is referred to as being "electrically connected" to another layer, region, or element, it may be "directly electrically connected" to the other layer, region, or element or may be "indirectly electrically connected" to the other layer, region, or element with another layer, region, or element interposed therebetween.

The x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

In the case where an illustrative embodiment may be implemented differently, a predetermined process order may be performed in the order different from the described order. In an embodiment, two processes successively described may be simultaneously performed substantially and performed in the opposite order.

Hereinafter, embodiments will be described with reference to the accompanying drawings, wherein like reference numerals refer to like elements throughout and a repeated description thereof is omitted. Sizes of elements in the drawings may be exaggerated or reduced for convenience of explanation. In an embodiment, the size and thickness of each element shown in the drawings are arbitrarily represented for convenience of description, and thus, the disclosure is not necessarily limited thereto.

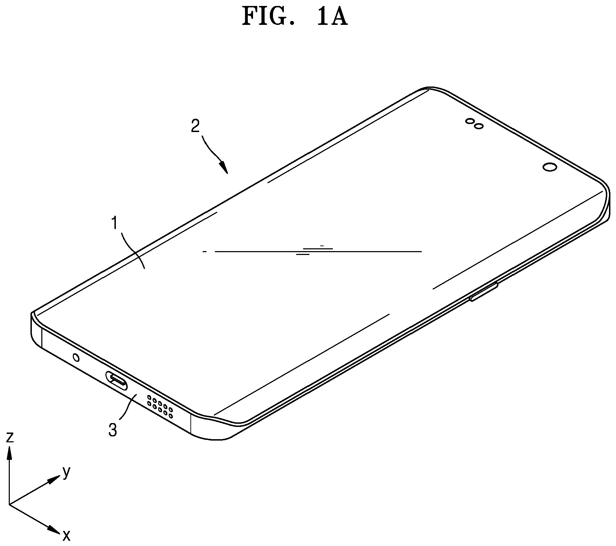

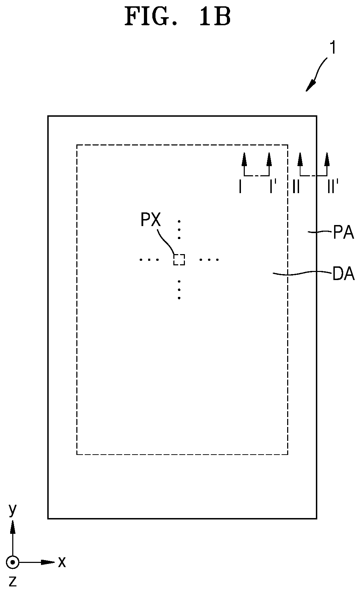

FIG. 1A is a schematic perspective view of an embodiment of an electronic apparatus 2. FIG. 1B is a schematic plan view of an embodiment of a display apparatus 1.

Referring to FIGS. 1A and 1B, the display apparatus 1 is an apparatus which displays moving images or still images, and the electronic apparatus 2 may display a screen or to input or output data.

Although it is shown in FIG. 1A that the display apparatus 1 is used in a mobile phone, the disclosure is not limited thereto. In an embodiment, the display apparatus 1 may be used as a display screen in various electronic apparatuses including televisions, notebook computers, monitors, advertisement boards, Internet of things ("loT") apparatuses as well as portable electronic apparatuses including mobile phones, smartphones, tablet personal computers, mobile communication terminals, electronic organizers, electronic books, portable multimedia players ("PMPs"), navigations, and ultra mobile personal computers ("UMPCs").

Additionally, in an embodiment, the display apparatus 1 in an embodiment may be used in electronic apparatuses such as wearable devices including smartwatches, watchphones, glasses-type displays, and head-mounted displays ("HMDs"). In an embodiment, the display apparatus 1 is applicable to a display screen in various electronic apparatuses, such as a display screen in instrument panels for automobiles, center fascias for automobiles, or center information displays ("CIDs") arranged on a dashboard, room mirror displays that replace side mirrors of automobiles, and displays of an entertainment system arranged on the backside of front seats for backseat passengers in automobiles.

In an embodiment, the display apparatus 1 may be received in a housing 3 of the electronic apparatus 2. The housing 3 may be a cover protecting inner elements such as the display apparatus 1 and forming the appearance of the electronic apparatus 2. In addition, the display apparatus 1 may be connected to an electronic module of the electronic apparatus 2 and driven on the electronic apparatus 2. Hereinafter, the display apparatus 1 is mainly described.

As shown in FIG. 1B, the display apparatus 1 may include a display area DA and a peripheral area PA, wherein a plurality of pixels PX is arranged in the display area DA, and the peripheral area PA is outside the display area DA. Specifically, the peripheral area PA may surround the display area DA entirely.

Each pixel PX of the display apparatus 1 is a region that may emit light of a preset color. The display apparatus 1 may display images by light from the pixels PX. In an embodiment, each pixel PX may emit red, green, or blue light. As shown in FIG. 1B, the display area DA may have a polygonal shape including a quadrangular shape. In an embodiment, the display area DA may have a quadrangular shape, e.g., rectangular shape in which a horizontal length thereof is less than a vertical length, a rectangular shape in which a horizontal length thereof is greater than a vertical length, or a square shape. In an alternative embodiment, the display area DA may have various shapes such as an elliptical shape or a circular shape.

The peripheral area PA may be a non-display area in which the pixels PX are not arranged. A driver or the like which provides electrical signals or power to the pixels PX may be arranged in the peripheral area PA. A plurality of pads (not shown) may be arranged in the peripheral area PA, wherein the pads are a region to which electronic elements or a printed circuit board may be electrically connected. The pads may be spaced apart from each other in the peripheral area PA and electrically connected to a printed circuit board or an integrated circuit element.

Hereinafter, although an organic light-emitting display apparatus is described in the display apparatus 1 in an embodiment, the display apparatus 1 is not limited thereto. In another embodiment, the display apparatus 1 in an embodiment may be an inorganic light-emitting display apparatus or a quantum-dot light-emitting display apparatus. In an embodiment, an emission layer of the display element of the display apparatus 1 may include an organic material or an inorganic material. In addition, the display apparatus 1 may include the emission layer and a quantum-dot layer disposed on a path of light emitted from the emission layer.

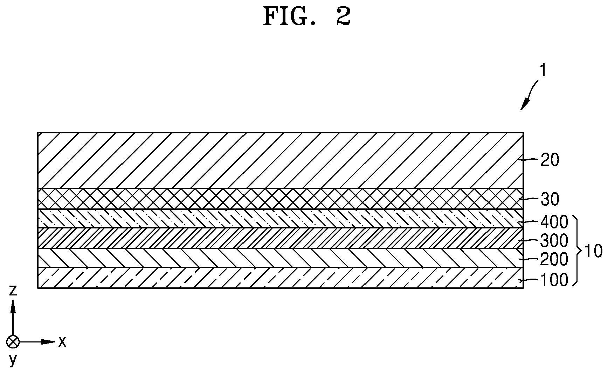

FIG. 2 is a schematic side view of an embodiment of the display apparatus 1. As shown in FIG. 2, the display apparatus 1 may include a display panel 10, a cover window 20, and an organic planarization layer 30.

The display panel 10 may display images. That is, it may be understood that images displayed by the display apparatus 1 is implemented by the display panel 10. The display panel 10 may include a plurality of display elements, and the plurality of display elements may emit light. Accordingly, the display panel 10 may display images through light emitted from the plurality of display elements.

The display panel 10 may include a substrate 100, a display element layer 200, an encapsulation layer 300, and a touch sensor layer 400. The substrate 100 may include glass, metal, or polymer resin. The substrate 100 needs to be flexible or bendable. In this case, the substrate 100 may include polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 may have a multi-layered structure including two layers each including the polymer resin, and a barrier layer including an inorganic material (such as silicon oxide (SiOₓ), silicon nitride (SiNₓ), and silicon oxynitride (SiOₓN_{y})) therebetween. However, various modifications may be made.

The display element layer 200 may be disposed on the substrate 100. The display element layer 200 may include the display elements and be a layer displaying images. Specifically, the display element layer 200 may include the display elements and pixel circuits electrically connected to the display elements. In addition, the display element layer 200 may include scan lines, data lines, power lines connected to the pixel circuit, a scan driver, and fan-out lines, and the scan driver applies scan signals to the scan lines, and the fan-out lines connect the data lines to a display driver.

In an embodiment, the display element may be an organic light-emitting diode including an organic emission layer. In an alternative embodiment, the display element may be a light-emitting diode ("LED"). The size of the LED may be microscales or nanoscales. In an embodiment, the light-emitting diode may be a micro light-emitting diode. In an alternative embodiment, the light-emitting diode may be a nanorod light-emitting diode. The nanorod light-emitting diode may include gallium nitride (GaN). In an embodiment, a color-converting layer may be disposed on the nano-rod light-emitting diode. The color-converting layer may include quantum dots. In an alternative embodiment, the display element may be a quantum-dot light-emitting diode including a quantum-dot emission layer. In an alternative embodiment, the display element may be an inorganic light-emitting diode including an inorganic semiconductor.

The encapsulation layer 300 for encapsulating the display element may be disposed on the display element layer 200. The encapsulation layer 300 may include at least one inorganic encapsulation layer and at least one organic encapsulation layer. Because the display element may be easily damaged by external moisture, oxygen, or the like, the encapsulation layer 300 may protect the display element by covering the display element.

The touch sensor layer 400 may be disposed on the encapsulation layer 300. The touch sensor layer 400 may be a layer for sensing an external input such as a user's touch input. The touch sensor layer 400 may sense a user's touch input using, e.g., a capacitive method. However, in the disclosure, a method of operating the touch sensor layer 400 is not particularly limited. In an embodiment, the touch sensor layer 400 may sense an external input by an electromagnetic induction method or a pressure sensing method. The touch sensor layer 400 may include sensing electrodes to sense a touch input.

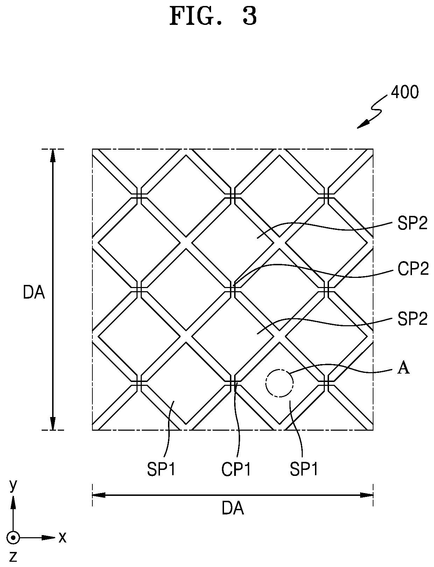

As shown in FIG. 3, which is a schematic plan view of a portion of the touch sensor layer 400 of FIG. 2, the touch sensor layer 400 may include a plurality of first sensing electrodes SP1 arranged in a first direction (e.g., an x axis direction), and a plurality of second sensing electrodes SP2 arranged in a second direction (e.g., a y axis direction) crossing the first direction. The first direction and the second direction may cross each other perpendicularly. That is, FIG .2 schematically shows sensing electrodes included in the touch sensor layer 400.

First sensing electrodes SP1 next (adjacent) to each other may be electrically connected to each other through a first connection electrode CP1. Second sensing electrodes SP2 next (adjacent) to each other may be electrically connected to each other through a second connection electrode CP2. The first sensing electrodes SP1 and the second sensing electrodes SP2 include a conductive layer, and the conductive layer may include a conductive material. In an embodiment, the conductive layer may include molybdenum (Mo), aluminium (Al), copper (Cu), or titanium (Ti), and include a single layer or a multi-layered structure including the above materials. In an embodiment, the conductive layer may have a structure of Ti/Al/Ti in which a titanium layer, an aluminium layer, and a titanium layer are sequentially stacked. Each of the first connection electrode CP1 and the second connection electrode CP2 may include the above-described conductive layer.

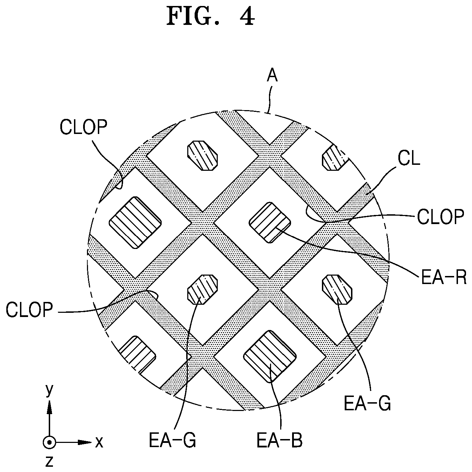

Each of the sensing electrodes and the connection electrodes may have a mesh structure including a plurality of openings. In an embodiment, as shown in FIG. 4, which is an enlarged plan view of a region A of FIG. 3, each first sensing electrode SP1 may be formed in a touch conductive layer CL. The touch conductive layer CL may define each of a plurality of conductive layer openings CLOP. That is, a body portion of the touch conductive layer CL may surround each conductive layer opening CLOP. Accordingly, the touch conductive layer CL may form a mesh structure. In other words, the first sensing electrode SP1 may have a mesh structure including a plurality of openings. Likewise, each of the second sensing electrodes SP2, each of the first connection electrodes CP1, and each of the second connection electrodes CP2 may also have a mesh structure.

Each conductive layer opening CLOP of the touch conductive layer CL may overlap an emission area of each display element. In an embodiment, each conductive layer opening CLOP may overlap an emission area EA-R of a display element emitting red light, an emission area EA-G of a display element emitting green light, or an emission area EA-B of a display element emitting blue light.

Although it is shown in FIG. 4 that an entirety of each of the conductive layer openings CLOP is surrounded by the body portion of the touch conductive layer CL and is not spatially extended to each other, the disclosure is not limited thereto. In an embodiment, at least one of the plurality of conductive layer openings CLOP may be partially surrounded by the body portion of the touch conductive layer CL. In this case, the conductive layer openings CLOP next (adjacent) to each other may be spatially connected to each other.

The cover window 20 may be disposed on the display panel 10. Specifically, the cover window 20 may be disposed on the upper surface (a +z direction) of the display panel 10. Here, the 'upper surface' of the display panel 10 may be defined as a surface facing a direction in which the display panel 10 displays images. In an embodiment, the cover window 20 may be disposed to cover the upper surface of the display panel 10. The cover window 20 may protect the upper surface of the display panel 10. In addition, because the cover window 20 forms the appearance of the display apparatus 1, the cover window 20 may include a plane and a curved surface corresponding to the shape of the display apparatus 1.

The cover window 20 may have a relatively high transmittance to transmit light emitted from the display panel 10, and have a thin thickness to reduce the weight of the display apparatus 1. In addition, the cover window 20 may have relatively high strength and hardness to protect the display panel 10 from external impacts. The cover window 20 may be a flexible window. The cover window 20 may protect the display panel 10 while easily bending according to external force without occurrence of cracks or the like.

The cover window 20 may include glass, sapphire, or plastic. In an embodiment, the cover window 20 may be an ultra-thin tempered glass UTG^{®} whose strength is strengthened by chemical strengthening or thermal strengthening, or a colorless polyimide ("CPI"). The cover window 20 may have a structure in which a flexible polymer layer is disposed on one surface of a glass substrate, or include only a polymer layer. Images displayed by the display panel 10 may be provided to users through the transparent cover window 20.

The organic planarization layer 30 may be disposed between the display panel 10 and the cover window 20. The organic planarization layer 30 may planarize a step difference in the lower portion such that the cover window 20 in the upper portion is easily attached to the display panel 10. In addition, external light reflection due to the touch conductive layers of the display panel 10 may be prevented from being viewed to users.

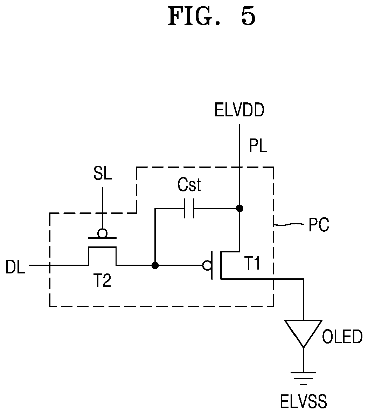

FIG. 5 is an equivalent circuit diagram of a pixel circuit PC included in the display apparatus 1 of FIG. 1B. The pixel circuit PC may be electrically connected to the display element, and one display element may correspond to one pixel. In FIG. 5, an organic light-emitting diode OLED is shown as the display element. In an embodiment, the display element may emit red, green, or blue light.

The pixel circuit PC may include a first transistor T1, a second transistor T2, and a storage capacitor Cst. The second transistor T2 is a switching thin-film transistor, may be connected to a scan line SL and a data line DL and be turned on according to a switching signal and transfer a data signal to the first transistor T1, the data signal being input from the data line DL, and the switching signal being input from the scan line SL. The storage capacitor Cst includes one end electrically connected to the second transistor T2, and another end electrically connected to a driving voltage line PL. The storage capacitor Cst may store a voltage corresponding to a difference between a voltage transferred from the second transistor T2 and a driving power voltage ELVDD supplied to the driving voltage line PL.

The first transistor T1 is a driving transistor, may be connected to the driving voltage line PL and the storage capacitor Cst and control the magnitude of a driving current according to the voltage stored in the storage capacitor Cst, the driving current flowing from the driving voltage line PL to the organic light-emitting diode OLED. The organic light-emitting diode OLED may emit light having a preset brightness corresponding to the driving current. An opposite electrode of the organic light-emitting diode OLED may receive an electrode power voltage ELVSS.

Although it is described with reference to FIG. 5 that the pixel circuit PC includes two transistors and one storage capacitor, the disclosure is not limited thereto. In an embodiment, the number of transistors and the number of storage capacitors may be variously changed according to the design of the pixel circuit PC.

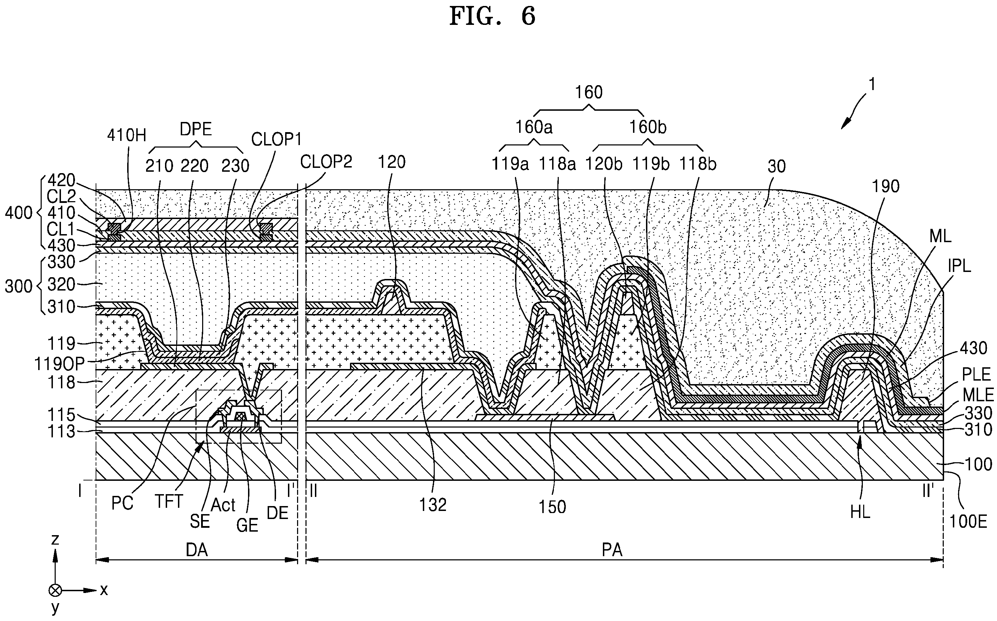

FIG. 6 is a schematic cross-sectional view of the display apparatus 1 of FIG. 1B, taken along lines I-I' and II-II' of FIG. 1B. As understood by those of ordinary skill in the art, the display apparatus 1 may further include various elements in addition to the elements shown in FIG. 6. For convenience of description, the cover window 20 is omitted in FIG. 6.

As shown in FIG. 6, the display apparatus 1 includes the substrate 100. As described above, the display apparatus 1 includes the display panel 10, and the display panel 10 (refer to FIG. 2) includes the substrate 100. That is, because the display apparatus 1 includes the substrate 100, the substrate 100 includes the display area DA and the peripheral area PA. Hereinafter, for convenience, description is made on the assumption that the substrate 100 includes the display area DA and the peripheral area PA.

A display element DPE and the pixel circuit PC to which the display element DPE is electrically connected may be arranged in the display area DA of the substrate 100. When the display element DPE is electrically connected to the pixel circuit PC, it may be understood that a pixel electrode 210 of the display element DPE is electrically connected to a transistor TFT of the pixel circuit PC.

Specifically, the pixel circuit PC may be disposed in the display area DA of the substrate 100. As described above, the pixel circuit PC may include a plurality of transistors and a storage capacitor Cst (refer to FIG. 5). However, for convenience of illustration, FIG. 6 shows only one transistor TFT, and the transistor TFT may correspond to the first transistor T1 (refer to FIG. 5) described above. That is, the transistor TFT included in the pixel circuit PC may be disposed in the display area DA of the substrate 100.

Although not shown, a buffer layer (not shown) including an inorganic insulating material such as silicon oxide (SiO_{X}), silicon nitride (SiN_{X}), and/or silicon oxynitride (SiO_{X}N_{Y}) may be disposed between the transistor TFT and the substrate 100. In an embodiment, the buffer layer may be formed on an entirety of the surface of the substrate 100. In this case, the buffer layer may be also disposed in the peripheral area PA. The buffer layer may increase flatness of the upper surface of the substrate 100, or prevent or reduce impurities from the substrate 100 or the like penetrating into a semiconductor layer Act of the transistor TFT.

As shown in FIG. 6, the transistor TFT may include the semiconductor layer Act including amorphous silicon, polycrystalline silicon, an organic semiconductor material, or an oxide semiconductor material. The transistor TFT may include a gate electrode GE, a source electrode SE, and a drain electrode DE.

The semiconductor layer Act may be disposed on the substrate 100. The semiconductor layer Act may include a channel region, a source region, and a drain region, the source region and the drain region being doped with impurities. The gate electrode GE may be disposed over the semiconductor layer Act to overlap the channel region of the semiconductor layer Act. The gate electrode GE may include molybdenum (Mo), aluminium (Al), copper (Cu), or titanium (Ti), and include a single layer or a multi-layer including the above materials. In an embodiment, the gate electrode GE may include a Mo single layer and an Al layer or have a multi-layered structure of a Mo/Al/Mo.

To secure insulation between the semiconductor layer Act and the gate electrode GE, a gate insulating layer 113 may be disposed between the semiconductor layer Act and the gate electrode GE, wherein the gate insulating layer 113 includes an inorganic insulating material such as silicon oxide (SiO_{X}), silicon nitride (SiN_{X}), and/or silicon oxynitride (SiO_{X}N_{Y}). The gate insulating layer 113 may be formed on the entirety of the surface of the substrate 100. In this case, the gate insulating layer 113 may be also disposed in the peripheral area PA. The gate insulating layer 113 may include a single layer or a multi-layer including the above materials.

In addition, a first inter-insulating layer 115 may be disposed on the gate electrode GE, wherein first inter-insulating layer 115 includes an inorganic insulating material such as silicon oxide (SiO_{X}), silicon nitride (SiN_{X}), and/or silicon oxynitride (SiO_{X}N_{Y}). The first inter-insulating layer 115 may be formed on the entirety of the surface of the substrate 100. In this case, the first inter-insulating layer 115 may be also disposed in the peripheral area PA. The first inter-insulating layer 115 may include a single layer or a multi-layered structure including the above materials.

The source electrode SE and the drain electrode DE may be disposed on the first inter-insulating layer 115. The source electrode SE and the drain electrode DE may each be connected to the semiconductor layer Act through a contact hole defined in the gate insulating layer 113 and the first inter-insulating layer 115. The source electrode SE and the drain electrode DE may include molybdenum (Mo), aluminium (Al), copper (Cu), or titanium (Ti), and include a single layer or a multi-layer including the above materials. In an embodiment, the source electrode SE and the drain electrode DE may have a multi-layered structure of Ti/Al/Ti.

An organic insulating layer 118 may be disposed on the source electrode SE and the drain electrode DE. Specifically, the organic insulating layer 118 may be disposed on the source electrode SE and the drain electrode DE to cover the transistor TFT. The display element DPE may be disposed on the organic insulating layer 118, and the organic insulating layer 118 may provide a flat upper surface such that the pixel electrode 210 of the display element DPE is formed flat.

The organic insulating layer 118 may include an organic insulating material. In an embodiment, the organic insulating layer 118 may include a general-purpose polymer such as benzocyclobutene ("BCB"), polyimide, hexamethyldisiloxane ("HMDSO"), polymethylmethacrylate ("PMMA") or polystyrene ("PS"), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, and any combinations thereof. The organic insulating layer 118 may include a single layer or a multi-layer including the above materials.

Although not shown in FIG. 6, a second inter-insulating layer (not shown) may be further disposed under the organic insulating layer 118. The second inter-insulating layer may include an inorganic insulating material such as silicon oxide (SiO_{X}), silicon nitride (SiN_{X}), and/or silicon oxynitride (SiO_{X}N_{Y}).

As described above, the display element DPE may be disposed on the organic insulating layer 118. In FIG. 6, an organic light-emitting diode is shown as the display element DPE. The display element DPE may include the pixel electrode 210, an opposite electrode 230, and an emission layer 220 disposed therebetween, for example. As shown in FIG. 6, the pixel electrode 210 may be electrically connected to the transistor TFT by being in contact with one of the source electrode SE and the drain electrode DE through a contact hole defined in the organic insulating layer 118.

The pixel electrode 210 may include a conductive oxide such as indium tin oxide ("ITO"), indium zinc oxide ("IZO"), zinc oxide (ZnO), indium oxide (In₂O₃), indium gallium oxide ("IGO"), or aluminium zinc oxide ("AZO"). The pixel electrode 210 may include a reflective layer including silver (Ag), magnesium (Mg), aluminium (Al), platinum (Pt), palladium (Pd), gold (Au), nickel (Ni), neodymium (Nd), iridium (Ir), chromium (Cr), or any combinations thereof. In an embodiment, the pixel electrode 210 may have a structure including layers on/under the reflective layer, the layers including ITO, IZO, ZnO, or In₂O₃. In this case, the pixel electrode 210 may have a stack structure of ITO/Ag/ITO.

The pixel-defining layer 119 may be disposed on the organic insulating layer 118. The pixel-defining layer 119 may define an opening exposing each pixel opening 119OP corresponding to a pixel, that is, at least a central portion of the pixel electrode 210. That is, an emission area, that is, the size and shape of a pixel may be defined by the pixel opening 119OP of the pixel-defining layer 119. In addition, as shown in FIG. 6, the pixel-defining layer 119 may prevent arcs or the like from occurring at the edges of the pixel electrode 210 by increasing a distance between the edges of the pixel electrode 210 and the opposite electrode 230. The pixel-defining layer 119 may include an organic material such as polyimide or HMDSO.

In addition, a spacer 120 may be disposed on the pixel-defining layer 119 in the peripheral area PA. The spacer 120 may protrude in a direction from the pixel-defining layer 119 to the encapsulation layer 300 and may be intended to prevent defects caused by mask chopping or the like during the process. The spacer 120 may include an organic material such as polyimide or hexamethyldisiloxane ("HMDSO").

The emission layer 220 formed to correspond to the pixel electrode 210 may be disposed inside the pixel opening 119OP of the pixel-defining layer 119. The emission layer 220 may include a polymer material or a low-molecular weight material and emit red, green, blue, or white light. In an embodiment, the emission layer 220 may include a polymer material such as a polyphenylene vinylene ("PPV")-based material and a polyfluorene-based material. The emission layer 220 may be formed by screen printing, inkjet printing, laser induced thermal imaging ("LITI"), or the like. However, the disclosure is not limited thereto.

In an embodiment, a functional layer (not shown) may be disposed under and on the emission layer 220. The functional layer may include a hole injection layer ("HIL"), a hole transport layer ("HTL"), an electron transport layer ("ETL"), and/or an electron injection layer ("EIL"). The functional layer may be integral over the plurality of pixel electrodes 210, or patterned to correspond to each of the plurality of pixel electrodes 210.

The opposite electrode 230 is disposed in the display area DA and may be disposed to cover the display area DA as shown in FIG. 6. That is, the opposite electrode 230 may be unitary over the plurality of display elements DPE to correspond to the plurality of pixel electrodes 210. The opposite electrode 230 may include a light-transmissive conductive layer including indium tin oxide ("ITO"), In₂O₃, or indium zinc oxide ("IZO"), and include a semi-transmissive layer including metal such as aluminium (Al) or silver (Ag). In an embodiment, the opposite electrode 230 may be a semi-transmissive layer including magnesium (Mg) and silver (Ag).

The opposite electrode 230 is electrically connected to a power supply line 150 disposed in the peripheral area PA. Specifically, as shown in FIG. 6, the opposite electrode 230 is electrically connected to the power supply line 150 through openings of the organic insulating layer 118 and the pixel-defining layer 119 covering the power supply line 150. Accordingly, the power supply line 150 may apply a power voltage to the display element DPE. The power supply line 150 may include the same material as that of the source electrode SE and the drain electrode DE, and a connection conductive layer 132 may be disposed between the opposite electrode 230 and the power supply line 150.

A dam portion 160 and a crack dam 190 are arranged in the peripheral area PA of the substrate 100. The dam portion 160 may be disposed to be next (adjacent) to the display area DA, and the crack dam 190 may be disposed to be next (adjacent) to an edge 100E of the substrate 100. That is, the crack dam 190 may be disposed between the dam portion 160 and the edge 100E of the substrate 100. In the specification, the "edge 100E of the substrate 100" means not only the actual edge of the substrate 100 but also a virtual surface extending in a thickness direction (e.g., a z axis direction) from the actual edge of the substrate 100. That is, the edge 100E of the substrate 100 may be a cutting line formed when cutting the mother board in which a plurality of display parts is formed along the edge of each of the plurality of display parts during the process of manufacturing the display apparatus 1.

As described above, the gate insulating layer 113 and the first inter-insulating layer 115 may be formed on the entirety of the surface of the substrate 100. Accordingly, the gate insulating layer 113 and the first inter-insulating layer 115 may be also formed in the peripheral area PA, and the dam portion 160 and the crack dam 190 may be disposed on the first inter-insulating layer 115.

Specifically, the dam portion 160 may cover at least a portion of the power supply line 150. The dam portion 160 may include a first dam 160a close to the display area DA, and a second dam 160b disposed between the first dam 160a and the edge 100E of the substrate 100. The first dam 160a may be disposed on the power supply line 150. The first dam 160a may have a structure in which a first layer 118a including the organic insulating layer 118 and a second layer 119a including the pixel-defining layer 119 are stacked. The first dam 160a may be stably disposed on the power supply line 150 by forming the first layer 118a in direct contact with the upper surface of the power supply line 150 using an organic material having a higher adhesive force than an inorganic material. However, the disclosure is not limited thereto, and the first dam 160a may include a different material and be formed at a different height.

The second dam 160b may be disposed outside the first dam 160a to cover one end of the power supply line 150. The second dam 160b may have a structure in which a first layer 118b including the organic insulating layer 118, a second layer 119b including the pixel-defining layer 119, and a third layer 120b including the spacer 120 are stacked. A height of the second dam 160b may be greater than a height of the first dam 160a.

Because the first layer 118b of the second dam 160b covers the end of the power supply line 150, the power supply line 150 may be prevented from being damaged during a process of manufacturing a backplane that uses heat or chemicals. In addition, the second dam 160b may prevent or reduce a material for forming an organic encapsulation layer 320 from leaking to the outside of the dam portion 160 during a process of forming the organic encapsulation layer 320. In addition, because the second dam 160b is formed higher than the first dam 160a, during a process of manufacturing a thin-film encapsulation layer (e.g., a first inorganic encapsulation layer 310) using a metal mask (not shown), the metal mask may be prevented from being in contact with the surface of the opposite electrode 230 and damaging the surface of the opposite electrode 230.

Although it is shown in FIG. 6 that the dam portion 160 includes the first dam 160a and the second dam 160b, that is, two dams, the disclosure is not limited thereto. The number, height, and material of the dam may be varied.

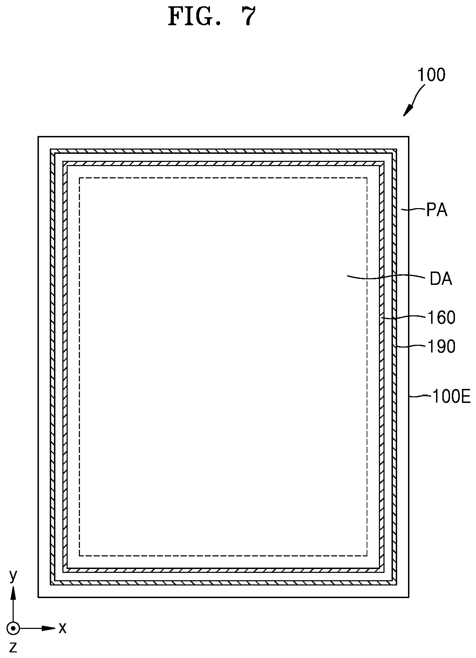

The dam portion 160 may be disposed in the peripheral area PA to surround the display area DA. As shown in FIG. 7, which is a schematic plan view of the display apparatus 1 in an embodiment, the dam portion 160 surrounds the display area DA. That is, FIG. 7 is a view to explain the position and shape of the dam portion 160 and the crack dam 190, and shows the dam portion 160 and the crack dam 190 in a plan view of the substrate 100.

The crack dam 190 may be disposed in the peripheral area PA to be next (adjacent) to the edge 100E of the substrate 100. The crack dam 190 may prevent or reduce cracks occurring from the edge 100E of the substrate 100 from propagating to the display area DA due to the inorganic insulating layer. The crack dam 190 may include an organic material. In an embodiment, the crack dam 190 may include the organic insulating layer 118. However, the disclosure is not limited thereto.

The crack dam 190 may be formed on the entirety of the surface of the substrate 100 to cover the ends of the inorganic insulating layers also disposed in the peripheral area PA. Specifically, the crack dam 190 may cover the ends of the gate insulating layer 113 and the first inter-insulating layer 115 disposed in the peripheral area PA. In an embodiment, at least some of the inorganic insulating layers are removed, and a hole HL exposing a portion of the upper surface of the substrate 100 may overlap the crack dam 190. That is, the hole HL may define an opening of the gate insulating layer 113 and an opening of the first inter-insulating layer 115 overlapping each other. The openings may be respectively formed through separate processes or may be simultaneously formed through the same process. Unlike this, instead of the hole HL exposing a portion of the upper surface of the substrate 100, a groove may overlap the crack dam 190. As shown in FIG. 7, the crack dam 190 may be disposed to be next (adjacent) to the edge 100E of the substrate 100 and may extend along the edge 100E of the substrate 100. That is, the crack dam 190 may be disposed to be closer to the edge 100E of the substrate 100 than the dam portion 160.

The encapsulation layer 300 may cover the display area DA and extend to the peripheral area PA. Because the display element DPE may be easily damaged by external moisture, oxygen, or the like, the encapsulation layer 300 may protect the display element DPE by covering the display element DPE. That is, the encapsulation layer 300 may be disposed on the display element DPE. That is, the encapsulation layer 300 may cover the display area DA entirely and extend to the peripheral area PA to cover at least a portion of the peripheral area PA.

The encapsulation layer 300 may include at least one inorganic encapsulation layer and at least one organic encapsulation layer. Specifically, as shown in FIG. 6, the encapsulation layer 300 may include the first inorganic encapsulation layer 310, the organic encapsulation layer 320, and a second inorganic encapsulation layer 330.

The first inorganic encapsulation layer 310 may cover the opposite electrode 230 and may include silicon oxide (SiO_{X}), silicon nitride (SiN_{X}), and/or silicon oxynitride (SiO_{X}N_{Y}). When desired, other layers including a capping layer may be disposed between the first inorganic encapsulation layer 310 and the opposite electrode 230. Because the first inorganic encapsulation layer 310 is formed along a structure thereunder, the upper surface of the first inorganic encapsulation layer 310 is not flat as shown in FIG. 6.

The organic encapsulation layer 320 may cover the first inorganic encapsulation layer 310 and, unlike the first inorganic encapsulation layer 310, the upper surface of the organic encapsulation layer 320 may be approximately flat. Specifically, the upper surface of a portion of the organic encapsulation layer 320 that corresponds to the display area DA may be approximately flat. The organic encapsulation layer 320 may include at least one material among polyethylene terephthalate, polyethylene naphthalate, polycarbonate, polyimide, polyethylene sulfonate, polyoxymethylene, polyarylate, and hexamethyldisiloxane.

The second inorganic encapsulation layer 330 may cover the organic encapsulation layer 320 and may include silicon oxide (SiO_{X}), silicon nitride (SiN_{X}), and/or silicon oxynitride (SiO_{X}N_{Y}). Because the second inorganic encapsulation layer 330 contacts the first inorganic encapsulation layer 310 at the edge outside the display area DA, the organic encapsulation layer 320 may not be exposed to the outside.

Because the encapsulation layer 300 includes the first inorganic encapsulation layer 310, the organic encapsulation layer 320, and the second inorganic encapsulation layer 330, even when cracks occur inside the encapsulation layer 300, the cracks may not be connected between the first inorganic encapsulation layer 310 and the organic encapsulation layer 320 or between the organic encapsulation layer 320 and the second inorganic encapsulation layer 330 through the above multi-layered structure. With this configuration, forming of a path through which external moisture or oxygen penetrates the display area DA may be prevented or reduced.

In an embodiment, the first inorganic encapsulation layer 310 and the second inorganic encapsulation layer 330 of the encapsulation layer 300 may be entirely deposited up to the edge 100E of the substrate 100. That is, each of the first inorganic encapsulation layer 310 and the second inorganic encapsulation layer 330 covering the display area DA may extend up to the edge 100E of the substrate 100. In another embodiment, the first inorganic encapsulation layer 310 and the second inorganic encapsulation layer 330 of the encapsulation layer 300 may be deposited in the display area DA and a portion of the peripheral area PA. That is, the first inorganic encapsulation layer 310 and the second inorganic encapsulation layer 330 may not be arranged in a portion of the peripheral area PA next (adjacent) to the edge 100E of the substrate 100.

The touch sensor layer 400 may be disposed on the encapsulation layer 300. The touch sensor layer 400 may include a touch conductive layer and a touch insulating layer covering the touch conductive layer. Specifically, the touch sensor layer 400 may include a first touch conductive layer CL1, a first touch insulating layer 410, a second touch conductive layer CL2, and a second touch insulating layer 420.

The first touch conductive layer CL1 may be disposed on the second inorganic encapsulation layer 330. In an embodiment, the first touch conductive layer CL1 may overlap the pixel-defining layer 119. The first touch conductive layer CL1 may not overlap the pixel opening 119OP of the pixel-defining layer 119. That is, the first touch conductive layer CL1 may define a first conductive layer opening CLOP1 overlapping the emission area of the display element DPE. Accordingly, the first touch conductive layer CL1 may have a mesh structure to pass the light emitted from the display element DPE.

The first touch conductive layer CL1 may include a conductive material. In an embodiment, the first touch conductive layer CL1 may include molybdenum (Mo), aluminium (Al), copper (Cu), or titanium (Ti), and include a single layer or a multi-layer including the above materials. In an embodiment, the first touch conductive layer CL1 may have a structure of Ti/Al/Ti in which a titanium layer, an aluminium layer, and a titanium layer are sequentially stacked.

The first touch insulating layer 410 may cover the first touch conductive layer CL1. That is, the first touch insulating layer 410 may be a touch insulating layer covering the touch conductive layer. The first touch insulating layer 410 may be a single layer or a multi-layered structure including an inorganic insulating material such as silicon oxide (SiO_{X}), silicon nitride (SiN_{X}), and/or silicon oxynitride (SiO_{X}N_{Y}). In an embodiment, the first touch insulating layer 410 may include an organic insulating material.

The second touch conductive layer CL2 may be disposed on the first touch insulating layer 410. In an embodiment, the second touch conductive layer CL2 may overlap the pixel-defining layer 119. The second touch conductive layer CL2 may not overlap the pixel opening 119OP of the pixel-defining layer 119. That is, the second touch conductive layer CL2 may define a second conductive layer opening CLOP2 overlapping the emission area of the display element DPE. Accordingly, the second touch conductive layer CL2 may have a mesh structure to pass the light emitted from the display element DPE.

The second touch conductive layer CL2 may include a conductive material. In an embodiment, the second touch conductive layer CL2 may include molybdenum (Mo), aluminium (Al), copper (Cu), or titanium (Ti), and include a single layer or a multi-layer including the above materials. In an embodiment, the second touch conductive layer CL2 may have a structure of Ti/Al/Ti in which a titanium layer, an aluminium layer, and a titanium layer are sequentially stacked.

In an embodiment, the second touch conductive layer CL2 may be electrically connected to the first touch conductive layer CL1 through a contact hole 410H defined in the first touch insulating layer 410. Each of the first sensing electrode SP1 and the second sensing electrode SP2 described with reference to FIG. 3 may be formed in a two-layered structure of the first touch conductive layer CL1 and the second touch conductive layer CL2 electrically connected to each other through a contact hole 410H of the first touch insulating layer 410 as shown in FIG. 6. In other words, the touch conductive layer CL of FIG. 4 may include the first touch conductive layer CL1 and the second touch conductive layer CL2, and the conductive layer opening CLOP of FIG. 4 may include a first conductive layer opening CLOP1 and a second conductive layer opening CLOP2.

The second touch insulating layer 420 may cover the second touch conductive layer CL2. That is, the second touch insulating layer 420 may be a touch insulating layer covering the touch conductive layer. The second touch insulating layer 420 may be a single layer or a multi-layered structure including an inorganic insulating material such as silicon oxide (SiO_{X}), silicon nitride (SiN_{X}), and/or silicon oxynitride (SiO_{X}N_{Y}). In an embodiment, the second touch insulating layer 420 may include an organic insulating material.

The touch sensor layer 400 may further include a touch buffer layer 430. The touch buffer layer 430 may be disposed between the encapsulation layer 300 and the first touch conductive layer CL1. Specifically, the touch buffer layer 430 may be disposed on the second inorganic encapsulation layer 330, and the first touch conductive layer CL1 may be disposed on the touch buffer layer 430. The touch buffer layer 430 may prevent a damage to the encapsulation layer 300 and block interference signals that may occur while the touch sensor layer 400 is driven. In an embodiment, the touch buffer layer 430 may be a single layer or a multi-layered structure including an inorganic insulating material such as silicon oxide (SiO_{X}), silicon nitride (SiN_{X}), and/or silicon oxynitride (SiO_{X}N_{Y}). In an embodiment, the touch buffer layer 430 may include an organic material. In claims, the touch buffer layer 430 may be denoted by an inorganic insulating layer.

The touch buffer layer 430 may be formed on the entirety of the surface of the substrate 100. In this case, the touch buffer layer 430 may be also disposed in the peripheral area PA. Accordingly, the touch buffer layer 430 may be entirely deposited up to the edge 100E of the substrate 100. That is, the touch buffer layer 430 covering the display area DA may extend up to the edge 100E of the substrate 100. Accordingly, the touch buffer layer 430 may cover the display element DPE in the display area DA, and the dam portion 160 and the crack dam 190 in the peripheral area PA. In an embodiment, the touch buffer layer 430 may be omitted. In this case, the first touch conductive layer CL1 may be disposed on the second inorganic encapsulation layer 330.

The organic planarization layer 30 may be disposed on the touch sensor layer 400. The organic planarization layer 30 may planarize a step difference in the lower portion such that the cover window 20 in the upper portion is easily attached to the display panel 10. The organic planarization layer 30 may include an organic material. In an embodiment, the organic planarization layer 30 may include at least one of an acryl-based resin, a methacryl-based resin, a polyisoprene, a vinyl-based resin, an epoxy-based resin, a urethane-based resin, a cellulose-based resin, and a perylene-based resin.

The organic planarization layer 30 covers the display area DA and the peripheral area PA. That is, the organic planarization layer 30 is disposed in the display area DA and the peripheral area PA. Specifically, the organic planarization layer 30 covering the display area DA may extend up to the edge 100E of the substrate 100. Accordingly, the organic planarization layer 30 covers the display element DPE in the display area DA, and the dam portion 160 and the crack dam 190 in the peripheral area PA.

A metal layer ML is disposed between the organic planarization layer 30 and the crack dam 190. Specifically, the metal layer ML may be disposed between a portion of the organic planarization layer 30 in the peripheral area PA and the crack dam 190. The metal layer ML covers the crack dam 190 and extends in a direction from the crack dam 190 to the edge 100E of the substrate 100. Accordingly, the metal layer ML may be disposed on a portion of the touch buffer layer 430 disposed between the crack dam 190 and the edge 100E of the substrate 100.

In an embodiment, the metal layer ML may cover an entirety of a portion of the touch buffer layer 430 disposed between the crack dam 190 and the edge 100E of the substrate 100. In other words, the metal layer ML may be entirely disposed on a portion of the touch buffer layer 430 disposed between the crack dam 190 and the edge 100E of the substrate 100. Accordingly, an end MLE of the metal layer ML may overlap the edge 100E of the substrate 100.

The metal layer ML may extend in a direction from the crack dam 190 to the dam portion 160. Accordingly, the metal layer ML may be disposed on a portion of the touch buffer layer 430 disposed between the crack dam 190 and the dam portion 160. In an embodiment, the metal layer ML may cover the dam portion 160. Although it is shown in FIG. 6 that the metal layer ML covers only a portion of the second dam 160b of the dam portion 160, the disclosure is not limited thereto. In an embodiment, the metal layer ML may cover the dam portion 160 entirely.

The metal layer ML may include the same material as a material of the first touch conductive layer CL1 or the second touch conductive layer CL2. In an embodiment, the metal layer ML may include a conductive material. In an embodiment, the metal layer ML may include molybdenum (Mo), aluminium (Al), copper (Cu), or titanium (Ti), and include a single layer or a multi-layer including the above materials. In an embodiment, the metal layer ML may have a structure of Ti/Al/Ti in which a titanium layer, an aluminium layer, and a titanium layer are sequentially stacked. That is, the metal layer ML may be simultaneously formed during the same process of forming at least one of the first touch conductive layer CL1 and the second touch conductive layer CL2. Accordingly, the metal layer ML may include the same material as a material of the first touch conductive layer CL1 or the second touch conductive layer CL2.

An inorganic protective layer IPL is disposed between the organic planarization layer 30 and the metal layer ML. Specifically, the inorganic protective layer IPL may be disposed on the metal layer ML, and the organic planarization layer 30 may be disposed on the inorganic protective layer IPL. The inorganic protective layer IPL is disposed on the metal layer ML to cover a portion of the metal layer ML. Accordingly, the metal layer ML may be prevented or reduced from being corroded by oxygen penetrating the lateral surface or the like of the display apparatus 1.

However, the inorganic protective layer IPL may be disposed on the metal layer ML to be spaced apart from the edge 100E of the substrate 100. Accordingly, an end PLE of the inorganic protective layer IPL may not overlap the edge 100E of the substrate 100, and the end PLE of the inorganic protective layer IPL may not overlap the end MLE of the metal layer ML. That is, the end PLE of the inorganic protective layer IPL may be disposed on the metal layer ML.

In an embodiment, the inorganic protective layer IPL may partially cover a portion of the metal layer ML disposed between the crack dam 190 and the edge 100E of the substrate 100. In other words, the inorganic protective layer IPL may be partially disposed on a portion of the metal layer ML disposed between the crack dam 190 and the edge 100E of the substrate 100. Specifically, a portion of the metal layer ML disposed between the crack dam 190 and the edge 100E of the substrate 100 may include a portion of the metal layer ML next (adjacent) to the crack dam 190 and a portion of the metal layer ML next (adjacent) to the edge 100E of the substrate 100. The inorganic protective layer IPL may cover a portion of the metal layer ML next (adjacent) to the crack dam 190 and may not cover a portion of the metal layer ML next (adjacent) to the edge 100E of the substrate 100. That is, the inorganic protective layer IPL may be disposed on a portion of the metal layer ML next (adjacent) to the crack dam 190, and the inorganic protective layer IPL may not be disposed on a portion of the metal layer ML next (adjacent) to the edge 100E of the substrate 100.

Accordingly, a portion of a part of the organic planarization layer 30 disposed between the crack dam 190 and the edge 100E of the substrate 100 is in direct contact with the metal layer ML. That is, a portion of the organic planarization layer 30 next (adjacent) to the edge 100E of the substrate 100 may be in direct contact with the metal layer ML. In other words, a portion of the metal layer ML next (adjacent) to the edge 100E of the substrate 100 may be in direct contact with the organic planarization layer 30.

The inorganic protective layer IPL may include the same material as a material of the first touch insulating layer 410 or the second touch insulating layer 420. In an embodiment, the inorganic protective layer IPL may be a single layer or a multi-layered structure including an inorganic insulating material such as silicon oxide (SiO_{X}), silicon nitride (SiN_{X}), and/or silicon oxynitride (SiO_{X}N_{Y}). That is, the inorganic protective layer IPL may be simultaneously formed during the same process of forming at least one of the first touch insulating layer 410 and the second touch insulating layer 420. Accordingly, the inorganic protective layer IPL may include the same material as a material of the first touch insulating layer 410 or the second touch insulating layer 420.

Generally, adhesive force between an organic material and an inorganic material may be low, and adhesive force between an organic material and metal may be high. Accordingly, in the case where a layer including an organic material is in direct contact with a layer including an inorganic material, the layer including an organic material may be easily detached from the layer including an inorganic material by external impacts. In an embodiment, in the case where the organic planarization layer 30 including an organic material is in direct contact with the touch buffer layer 430 or the inorganic protective layer IPL or the like including an inorganic material, the organic planarization layer 30 may be easily detached from the display panel 10 by external impacts or the like.

However, in the display apparatus 1 in an embodiment, a portion of a part of the organic planarization layer 30 disposed between the crack dam 190 and the edge 100E of the substrate 100 is in direct contact with the metal layer ML. Because adhesive force between an organic material and metal is greater than adhesive force between an organic material and an inorganic material, the organic planarization layer 30 may not be easily detached from the display panel 10 by external impacts or the like. That is, defect occurrence possibility may be reduced during the process of manufacturing the display apparatus 1. Although it is shown in FIG. 6 that the inorganic protective layer IPL covers an entirety of a portion of the metal layer ML disposed between the dam portion 160 and the crack dam 190, the disclosure is not limited thereto.

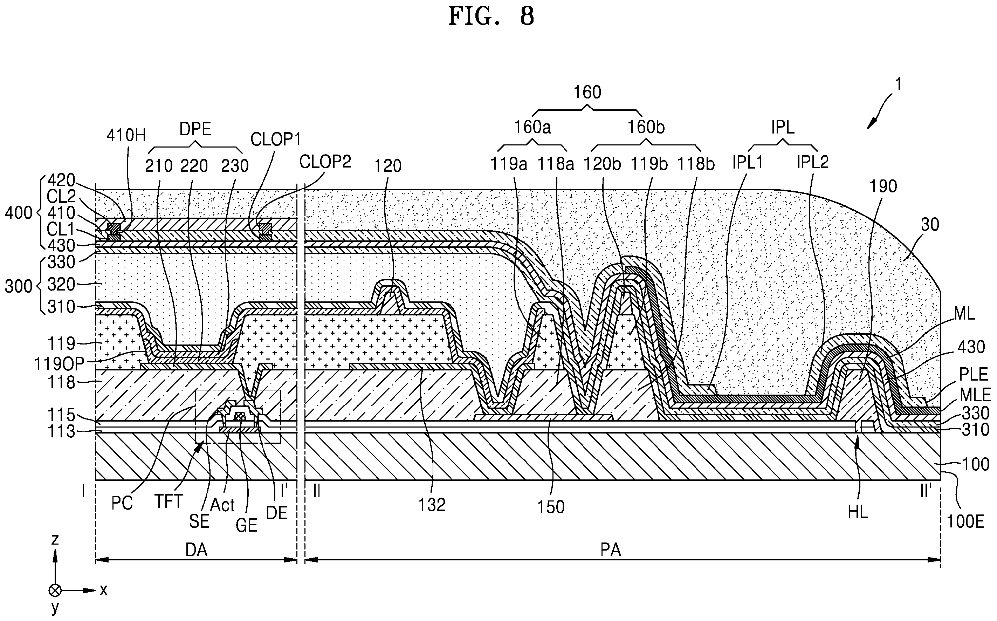

FIG. 8 is a schematic cross-sectional view of an embodiment of the display apparatus 1. Because the display apparatus 1 in an embodiment is similar to the display apparatus 1 described above with reference to FIGS. 1B to 7, differences from the display apparatus 1 described with reference to FIGS. 1B to 7 are mainly described below. In FIG. 8, the same reference numerals as those of FIGS. 1B to 7 denote the same members, and thus, repeated descriptions thereof are omitted. For convenience of description, the cover window 20 is omitted in FIG. 8.

The inorganic protective layer IPL of the display apparatus 1 in the embodiment described with reference to FIGS. 1B to 7 may be disposed on the metal layer ML to be spaced apart from the edge 100E of the substrate 100. The inorganic protective layer IPL of the display apparatus 1 in the illustrated embodiment may be also disposed on the metal layer ML to be spaced apart from the edge 100E of the substrate 100. However, in the display apparatus 1 in the illustrated embodiment, the inorganic protective layer IPL may partially cover a portion of the metal layer ML disposed between the dam portion 160 and the crack dam 190. That is, the inorganic protective layer IPL may be disposed on only a portion of a part of the metal layer ML disposed between the dam portion 160 and the crack dam 190. In an embodiment, the inorganic protective layer IPL may include a plurality of sub-protective layers. The sub-protective layers may be spaced apart from each other in a direction from the display area DA to the edge 100E of the substrate 100.

Specifically, the inorganic protective layer IPL may include a first inorganic protective layer IPL1 and a second inorganic protective layer IPL2. The first inorganic protective layer IPL1 and the second inorganic protective layer IPL2 may be spaced apart from each other. Specifically, the first inorganic protective layer IPL1 may be next (adjacent) to the dam portion 160, and the second inorganic protective layer IPL2 may be next (adjacent) to the crack dam 190. In an embodiment, the first inorganic protective layer IPL1 may cover a portion of the metal layer ML disposed on the dam portion 160. The second inorganic protective layer IPL2 may cover a portion of the metal layer ML disposed on the crack dam 190 and partially cover a portion of the metal layer ML disposed between the crack dam 190 and the edge 100E of the substrate 100. In other words, the second inorganic protective layer IPL2 may be partially disposed on a portion of the metal layer ML disposed between the crack dam 190 and the edge 100E of the substrate 100.

That is, the inorganic protective layer IPL does not cover a portion of a part of the metal layer ML disposed between the dam portion 160 and the crack dam 190. The inorganic protective layer IPL is not disposed on a portion of a part of the metal layer ML disposed between the dam portion 160 and the crack dam 190. Accordingly, a portion of a part of the organic planarization layer 30 disposed between the dam portion 160 and the crack dam 190 may be in direct contact with the metal layer ML. Accordingly, a contact area between the organic planarization layer 30 and the metal layer ML may increase. As described above, because adhesive force between an organic material and metal is greater than adhesive force between an organic material and an inorganic material, the organic planarization layer 30 may not be easily detached from the display panel 10 by external impacts or the like. That is, defect occurrence possibility may be reduced during the process of manufacturing the display apparatus 1. Although it is shown in FIGS. 6 and 8 that the metal layer ML covers an entirety of a portion of the touch buffer layer 430 disposed between the dam portion 160 and the crack dam 190, the disclosure is not limited thereto.

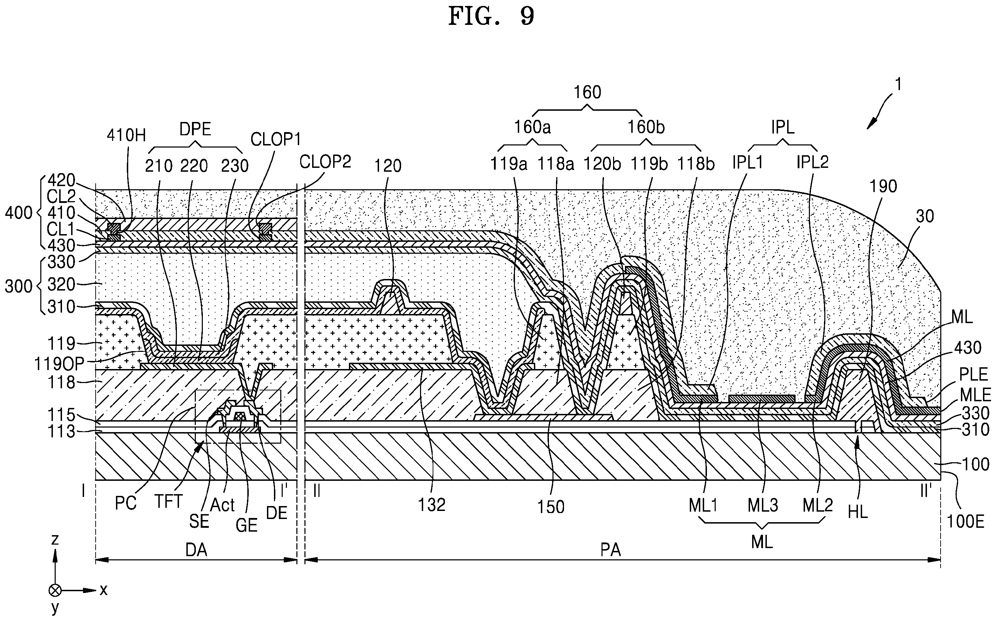

FIG. 9 is a schematic cross-sectional view of an embodiment of the display apparatus 1. Because the display apparatus 1 in an embodiment is similar to the display apparatus 1 described above with reference to FIG. 8, differences from the display apparatus 1 described with reference to FIG. 8 are mainly described below. In FIG. 9, the same reference numerals as those of FIG. 8 denote the same members, and thus, repeated descriptions thereof are omitted. For convenience of description, the cover window 20 is omitted in FIG. 9.

The inorganic protective layer IPL of the display apparatus 1 in the embodiment described with reference to FIG. 8 may include the first inorganic protective layer IPL1 and the second inorganic protective layer IPL2 apart from each other. The inorganic protective layer IPL of the display apparatus 1 in the embodiment may include the first inorganic protective layer IPL1 and the second inorganic protective layer IPL2 apart from each other. However, in the display apparatus 1 in the illustrated embodiment, the metal layer ML may partially cover a portion of the touch buffer layer 430 disposed between the dam portion 160 and the crack dam 190. That is, the metal layer ML may be disposed on only a portion of a part of the touch buffer layer 430 disposed between the dam portion 160 and the crack dam 190. In an embodiment, the metal layer ML may include a plurality of sub-metal layers. The sub-metal layers may be spaced apart from each other in a direction from the display area DA to the edge 100E of the substrate 100.

Specifically, the metal layer ML may include a first metal layer ML1, a second metal layer ML2, and a third metal layer ML3. The first metal layer ML1, the second metal layer ML2, and the third metal layer ML3 may be spaced apart from each other. Specifically, the first metal layer ML1 may be next (adjacent) to the dam portion 160, and the second metal layer ML2 may be next (adjacent) to the crack dam 190. The third metal layer ML3 may be disposed between the first metal layer ML1 and the second metal layer ML2.

In an embodiment, the first metal layer ML1 may cover a portion of the touch buffer layer 430 disposed on the dam portion 160. The second metal layer ML2 may cover a portion of the touch buffer layer 430 disposed on the crack dam 190 and cover a portion of the touch buffer layer 430 disposed between the crack dam 190 and the edge 100E of the substrate 100. The third metal layer ML3 may partially cover a portion of the touch metal layer 430 disposed between the dam portion 160 and the crack dam 190. In other words, the third metal layer ML3 may be partially disposed on a portion of the touch metal layer 430 disposed between the dam portion 160 and the crack dam 190.

That is, a portion of the metal layer ML disposed between the dam portion 160 and the crack dam 190 may be patterned. Accordingly, because the surface area of the metal layer ML increases, a contact area between the organic planarization layer 30 and the metal layer ML may increase. Accordingly, the organic planarization layer 30 may not be easily detached from the display panel 10 by external impacts or the like. That is, defect occurrence possibility may be reduced during the process of manufacturing the display apparatus 1. Although it is shown in FIGS. 6, 8, and 9 that the end MLE of the metal layer ML overlaps the edge 100E of the substrate 100, the disclosure is not limited thereto.

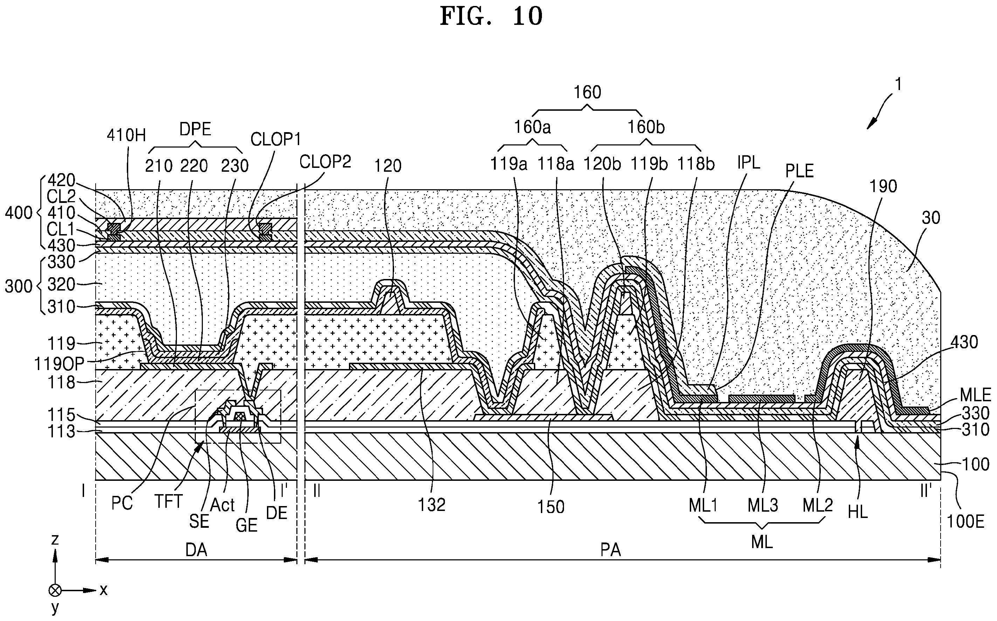

FIG. 10 is a schematic cross-sectional view of an embodiment of the display apparatus 1. Because the display apparatus 1 in an embodiment is similar to the display apparatus 1 described above with reference to FIG. 9, differences from the display apparatus 1 described with reference to FIG. 9 are mainly described below. In FIG. 10, the same reference numerals as those of FIG. 9 denote the same members, and thus, repeated descriptions thereof are omitted. For convenience of description, the cover window 20 is omitted in FIG. 10.

The metal layer ML of the display apparatus 1 in the embodiment described above with reference to FIG. 9 may include the first metal layer ML1, the second metal layer ML2, and the third metal layer ML3 apart from each other. The metal layer ML of the display apparatus 1 in the illustrated embodiment may include the first metal layer ML1, the second metal layer ML2, and the third metal layer ML3 apart from each other. However, in the display apparatus 1 in the illustrated embodiment, the end MLE of the metal layer ML may not overlap the edge 100E of the substrate 100. The end MLE of the metal layer ML may be disposed on a portion of the touch buffer layer 430 disposed between the crack dam 190 and the edge 100E of the substrate 100.

That is, the metal layer ML does not cover an entirety of a portion of the touch buffer layer 430 disposed between the crack dam 190 and the edge 100E of the substrate 100. In other words, the metal layer ML may be partially disposed on a portion of the touch buffer layer 430 disposed between the crack dam 190 and the edge 100E of the substrate 100.

Specifically, a portion of the touch buffer layer 430 disposed between the crack dam 190 and the edge 100E of the substrate 100 may include a portion of the touch buffer layer 430 next (adjacent) to the crack dam 190 and a portion of the touch buffer layer 430 next (adjacent) to the edge 100E of the substrate 100. The metal layer ML may cover a portion of the touch buffer layer 430 next (adjacent) to the crack dam 190 and may not cover a portion of the touch buffer layer 430 next (adjacent) to the edge 100E of the substrate 100. That is, the metal layer ML may be disposed on a portion of the touch buffer layer 430 next (adjacent) to the crack dam 190, and the metal layer ML may not be disposed on a portion of the touch buffer layer 430 next (adjacent) to the edge 100E of the substrate 100.

In this case, the organic planarization layer 30 may cover the end MLE of the metal layer ML. Because the organic planarization layer 30 covers the end MLE of the metal layer ML, the metal layer ML be prevented or reduced from be corroded by oxygen penetrating the lateral surface or the like of the display apparatus 1.

Accordingly, in the display apparatus 1 in the illustrated embodiment, there may not be the inorganic protective layer IPL corresponding to the second inorganic protective layer IPL2 of the display apparatus 1 described above with reference to FIG. 9. That is, the inorganic protective layer IPL of the display apparatus 1 in the illustrated embodiment may not cover a portion of the metal layer ML disposed on the crack dam 190 and may not cover a portion of the metal layer ML disposed between the crack dam 190 and the edge 100E of the substrate 100.

Even in this case, a portion of a part of the organic planarization layer 30 disposed between the crack dam 190 and the edge 100E of the substrate 100 may be in direct contact with the metal layer ML. Specifically, among the portions, a portion of the organic planarization layer 30 next (adjacent) to the edge 100E of the substrate 100 is in direct contact with the touch buffer layer 430, but a portion of the organic planarization layer 30 next (adjacent) to the crack dam 190 may be in direct contact with the metal layer ML. As described above, because adhesive force between an organic material and metal is greater than adhesive force between an organic material and an inorganic material, the organic planarization layer 30 may not be easily detached from the display panel 10 by external impacts or the like. That is, defect occurrence possibility may be reduced during the process of manufacturing the display apparatus 1.

Up to this point, although description has been made to the display apparatus 1, the disclosure is not limited thereto. A method of manufacturing the display apparatus 1 also falls within the scope of the disclosure. Hereinafter, the method of manufacturing the display apparatus 1 is described.

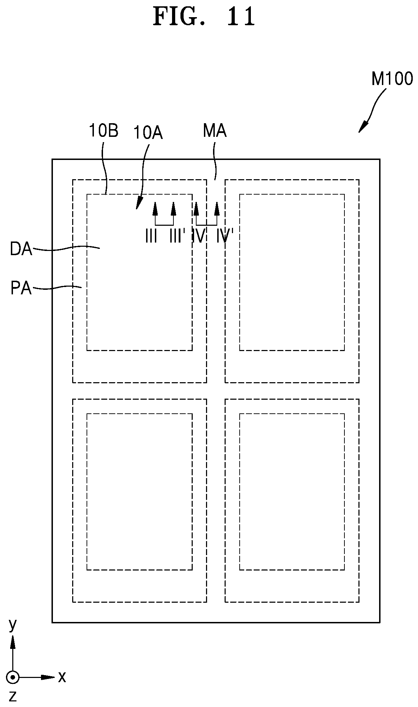

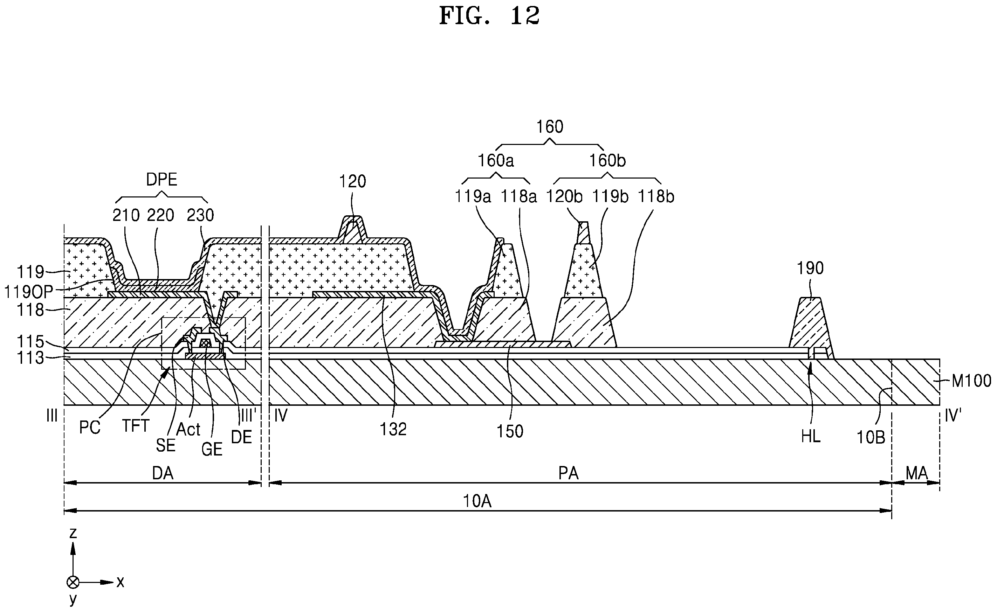

FIGS. 11 to 17 are schematic views showing a portion of a process of manufacturing the display apparatus 1 of FIG. 6. Specifically, FIG. 11 is a plan view of a mother board M100 for manufacturing the display apparatus 1, and FIGS. 12 to 17 are schematic cross-sectional views showing a portion of a process of manufacturing the display apparatus 1 of FIG. 6. Specifically, FIGS. 12 to 17 are schematic cross-sectional views showing a process of manufacturing the metal layer ML, the inorganic protective layer IPL, and the organic planarization layer 30 of the display apparatus 1 of FIG. 6. In FIGS. 12 to 17, for convenience of description, the method of manufacturing the display apparatus is described based in a cross-sectional views of the mother board M100, taken along line III-III' and IV-IV' of FIG. 11.

First, as shown in FIG. 11, the mother board M100 is prepared. The mother board M100 includes a panel area 10A and a margin area MA. The margin area MA surrounds the panel area 10A entirely. Accordingly, a border is formed between the margin area MA and the panel area 10A, and the border between the margin area MA and the panel area 10A may be denoted by a panel border 10B. In the specification, the panel border 10B denotes not only an actual border between the panel area 10A and the margin area MA but also a virtual surface extending in a thickness direction of the mother board M100 from the actual border between the panel area 10A and the margin area MA.

The panel area 10A includes the display area DA and the peripheral area PA. The panel area 10A of the mother board M100 is a region corresponding to the substrate 100 of the display apparatus 1 of FIG. 6, the display area DA of the mother board M100 is a region corresponding to the display area DA of the display apparatus 1 of FIG. 6, and the peripheral area PA of the mother board M100 is a region corresponding to the peripheral area PA of the display apparatus 1 of FIG. 6. That is, as described below, in the case of manufacturing the display apparatus 1 by cutting the mother board M100 along the panel border 10B, the display area DA of the mother board M100 may become the display area DA of the display apparatus 1 of FIG. 6, and the peripheral area PA of the mother board M100 may become the peripheral area PA of the display apparatus 1 of FIG. 6.

That is, the mother board M100 may include glass, metal, or polymer resin. The mother board M100 needs to be flexible or bendable. In this case, the mother board M100 may include polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate. The mother board M100 may have a multi-layered structure including two layers each including the polymer resin, and a barrier layer including an inorganic material (such as silicon oxide, silicon nitride, and silicon oxynitride) therebetween. However, various modifications may be made.

The mother board M100 may include a plurality of panel areas 10A. The plurality of panel areas 10A may be spaced apart from each other, and the margin area MA may surround each of the plurality of panel areas 10A.

Next, as shown in FIG. 12, the display element DPE, the dam portion 160, and the crack dam 190 may be formed. The display element DPE is formed in the display area DA. The dam portion 160 is formed in the peripheral area PA to be next (adjacent) to the display area DA, and the crack dam 190 is formed in the peripheral area PA to be next (adjacent) to the margin area MA.

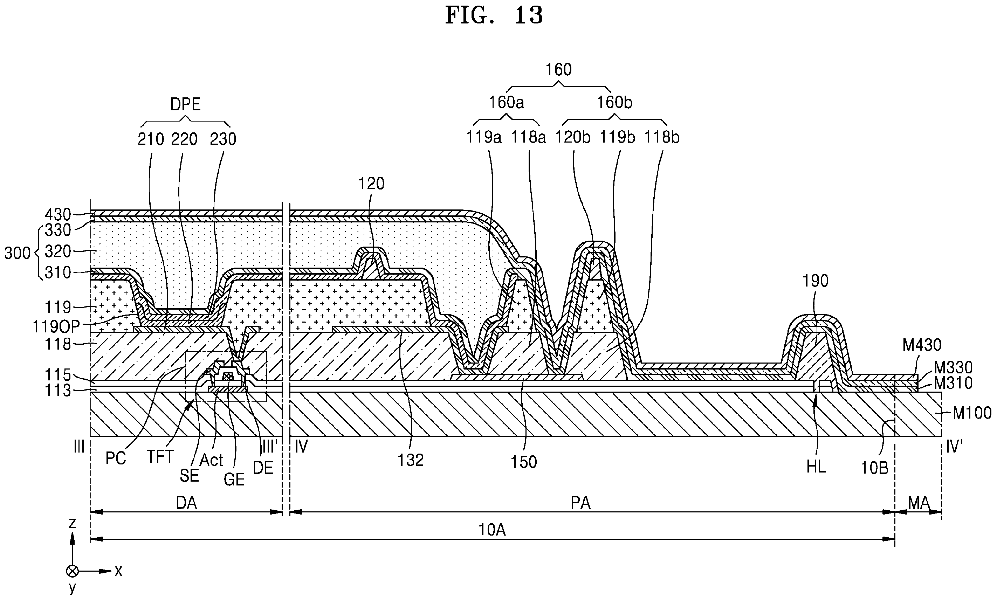

Next, as shown in FIG. 13, the touch buffer layer 430 may be formed over the display area DA and the peripheral area PA. Accordingly, the touch buffer layer 430 covers the display element DPE, the dam portion 160, and the crack dam 190. That is, the touch buffer layer 430 may be formed over the display area DA and the peripheral area PA to cover the display element DPE, the dam portion 160, and the crack dam 190.

Before forming the touch buffer layer 430, the encapsulation layer 300 may be formed over the substrate 100. The touch buffer layer 430, and the first inorganic encapsulation layer 310 and the second inorganic encapsulation layer 330 included in the encapsulation layer 300 may be formed in the entirety of the surface of the panel area 10A. During a process of forming each of the touch buffer layer 430, the first inorganic encapsulation layer 310, and the second inorganic encapsulation layer 330, the touch buffer layer 430, the first inorganic encapsulation layer 310, and the second inorganic encapsulation layer 330 may be formed to exceed the panel area 10A. Accordingly, a margin touch buffer layer M430, a first margin inorganic encapsulation layer M310, and a second margin inorganic encapsulation layer M330 may be formed in the margin area MA.

That is, the touch buffer layer 430 of FIGS. 13 to 17 corresponds to the touch buffer layer 430 of the display apparatus 1 of FIG. 6, the first inorganic encapsulation layer 310 of FIGS. 13 to 17 corresponds to the first inorganic encapsulation layer 310 of the display apparatus 1 of FIG. 6, and the second inorganic encapsulation layer 330 of FIGS. 13 to 17 corresponds to the second inorganic encapsulation layer 330 of the display apparatus 1 of FIG. 6. The margin touch buffer layer M430, the first margin inorganic encapsulation layer M310, and the second margin inorganic encapsulation layer M330 in the margin area MA may be portions removed during an operation of manufacturing the display apparatus 1 by cutting the mother board M100 along the panel border 10B described below. In claims, the touch buffer layer 430 may be denoted by an inorganic insulating layer, and the margin touch buffer layer M430 may be denoted by a margin inorganic insulating layer.

The margin touch buffer layer M430 may be unitary with the touch buffer layer 430 during the same process as a process of forming the touch buffer layer 430. Accordingly, the margin touch buffer layer M430 may include the same material as a material of the touch buffer layer 430. The first margin inorganic encapsulation layer M310 may be unitary with the first inorganic encapsulation layer 310 during the same process as a process of forming the first inorganic encapsulation layer 310. Accordingly, the first margin inorganic encapsulation layer M310 may include the same material as a material of the first inorganic encapsulation layer 310. The second margin inorganic encapsulation layer M330 may be unitary with the second inorganic encapsulation layer 330 during the same process as a process of forming the second inorganic encapsulation layer 330. Accordingly, the second margin inorganic encapsulation layer M330 may include the same material as a material of the second inorganic encapsulation layer 330.

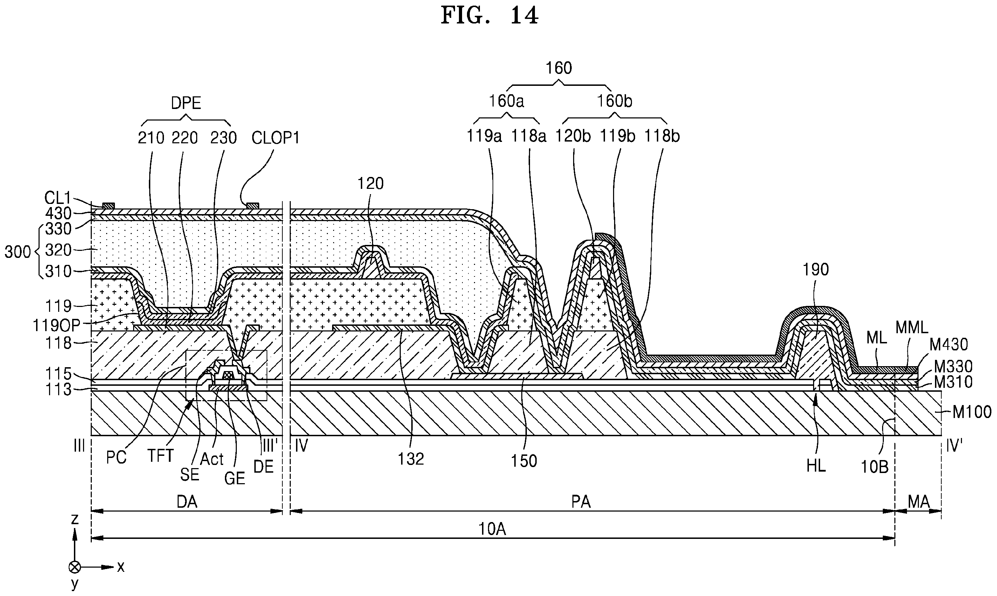

Next, as shown in FIG. 14, the metal layer ML may be formed on the touch buffer layer 430. Specifically, the metal layer ML is formed on the touch buffer layer 430 in the peripheral area PA, and the metal layer ML may be formed to cover the crack dam 190 and extend in a direction from the crack dam 190 to the panel border 10B.

The first touch conductive layer CL1 may be formed on the touch buffer layer 430 in the display area DA. The first touch conductive layer CL1 may be formed simultaneously during the same process as a process of forming the metal layer ML. Accordingly, the first touch conductive layer CL1 may include the same material as a material of the metal layer ML and have the same layered structure as a layered structure of the metal layer ML. That is, an operation of forming the metal layer ML on a portion of the touch buffer layer 430 disposed in the peripheral area PA may include an operation of forming the first touch conductive layer CL1 on a portion of the touch buffer layer 430 disposed in the display area DA. However, the disclosure is not limited thereto. In an embodiment, the second touch conductive layer CL2 may be simultaneously formed during the same process as a process of forming the metal layer ML.

Because the metal layer ML is formed to extend in a direction from the crack dam 190 to the panel border 10B, the metal layer ML may be formed to exceed the panel area 10A during the process of forming the metal layer ML. Accordingly, a margin metal layer MML may be formed in the margin area MA. That is, the metal layer ML of FIGS. 14 to 17 may correspond to the metal layer ML of the display apparatus 1 of FIG. 6, and the margin metal layer MML in the margin area MA may be a portion removed during an operation of manufacturing the display apparatus 1 by cutting the mother board M100 along the panel border 10B described below. The margin metal layer MML may be unitary during the same process as a process of forming the metal layer ML. Accordingly, the margin metal layer MML may include the same material as a material of the metal layer ML.

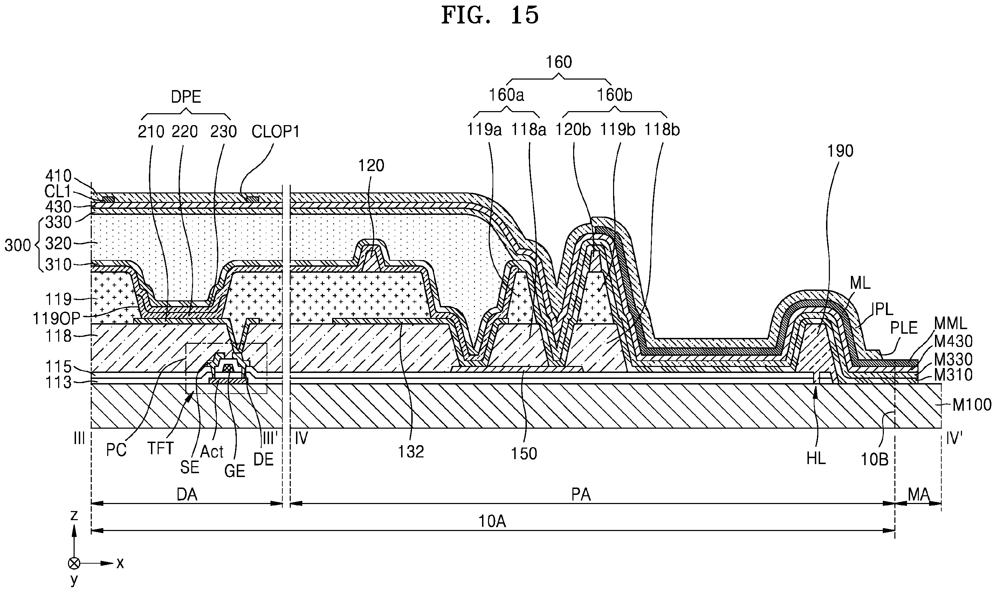

Next, as shown in FIG. 15, the inorganic protective layer IPL may be formed on the metal layer ML. The inorganic protective layer IPL covers a portion of the metal layer ML. That is, the inorganic protective layer IPL is formed on the metal layer ML to cover a portion of the metal layer ML. The inorganic protective layer IPL may be spaced apart from the panel border 10B. Accordingly, the end PLE of the inorganic protective layer IPL may be disposed on the metal layer ML. In an embodiment, the inorganic protective layer IPL may cover a portion of the metal layer ML next (adjacent) to the crack dam 190 and may not cover a portion of the metal layer ML next (adjacent) to the panel border 10B.

The first touch insulating layer 410 may be formed on the first touch conductive layer CL1 in the display area DA. The first touch insulating layer 410 may cover the first touch conductive layer CL1. The first touch insulating layer 410 may be simultaneously formed during the same process as a process of forming the inorganic protective layer IPL. Accordingly, the first touch insulating layer 410 may include the same material as a material of the inorganic protective layer IPL and have the same layered structure as a layered structure of the inorganic protective layer IPL. That is, an operation of forming the inorganic protective layer IPL on the metal layer ML disposed in the peripheral area PA may include an operation of forming the first touch insulating layer 410 on the first touch conductive layer CL1 disposed in the display area DA. However, the disclosure is not limited thereto. In an embodiment, the second touch insulating layer 420 may be simultaneously formed during the same process as a process of forming the inorganic protective layer IPL.

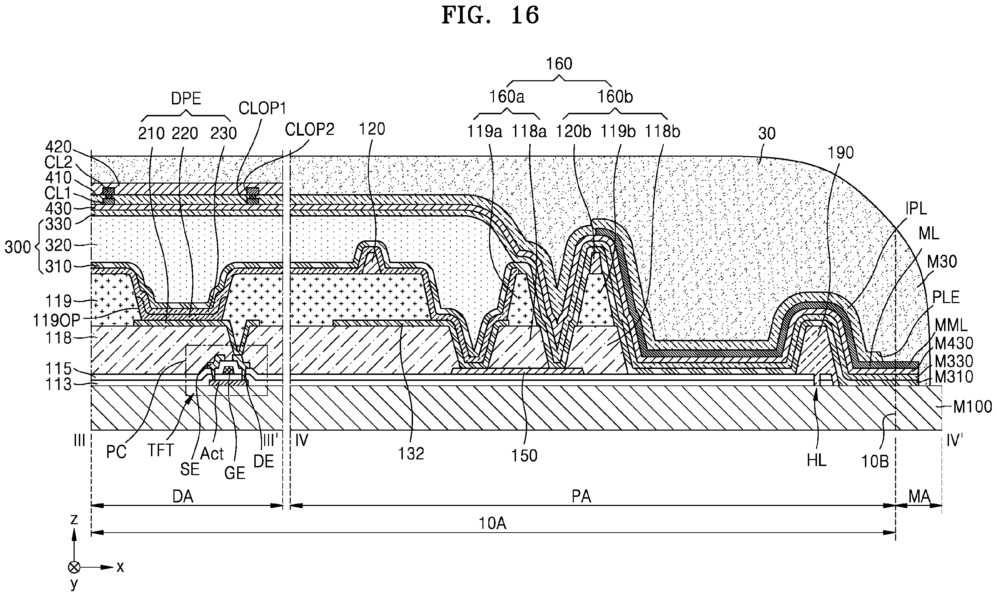

Next, as shown in FIG. 16, the organic planarization layer 30 may be formed over the display area DA and the peripheral area PA. The organic planarization layer 30 covers the inorganic protective layer IPL. That is, the organic planarization layer 30 is formed over the display area DA and the peripheral area PA to cover the inorganic protective layer IPL. Accordingly, a portion of a part of the organic planarization layer 30 disposed between the crack dam 190 and the panel border 10B may be in direct contact with the metal layer ML.

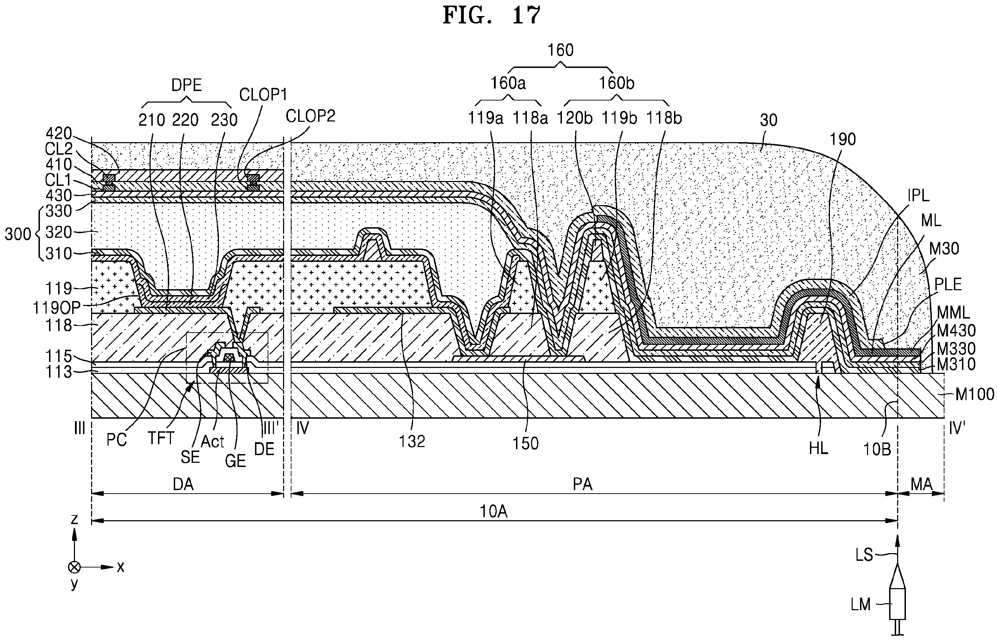

Because the organic planarization layer 30 is formed over the display area DA and the peripheral area PA, the organic planarization layer 30 may be formed to exceed the panel area 10A during the process of forming the organic planarization layer 30. Accordingly, a margin organic planarization layer M30 may be formed in the margin area MA. That is, the organic planarization layer 30 of FIGS. 16 and 17 may correspond to the organic planarization layer 30 of the display apparatus 1 of FIG. 6, and the margin organic planarization layer M30 in the margin area MA may be a portion removed during an operation of manufacturing the display apparatus 1 by cutting the mother board M100 along the panel border 10B described below. The margin organic planarization layer M30 may be unitary with the organic planarization layer 30 during the same process as a process of forming the organic planarization layer 30. Accordingly, the margin organic planarization layer M30 may include the same material as a material of the organic planarization layer 30.

Next, as shown in FIG. 17, the mother board M100 may be cut along the panel border 10B. Accordingly, the display panel 10 on which the organic planarization layer 30 is formed may be formed.

The cutting of the mother board M100 may be performed by a laser module LM. The laser module LM may irradiate a laser beam LS along the panel border 10B, and accordingly, separate the panel area 10A from the margin area MA. That is, the panel border 10B may be a cutting line. Accordingly, during a process of cutting the mother board M100 along the panel border 10B, the first margin inorganic encapsulation layer M310, the second margin inorganic encapsulation layer M330, the margin touch buffer layer M430, the margin metal layer MML, and the margin organic planarization layer M30 arranged in the margin area MA may be removed.

Generally, during the process of separating the panel area 10A from the margin area MA, a preset impact may be applied to the panel area 10A. Due to this impact, detachment between layers may occur in portions next (adjacent) to the panel border 10B. In contrast, in the method of manufacturing the display apparatus in the illustrated embodiment, a portion of a part of the organic planarization layer 30 disposed between the crack dam 190 and the panel border 10B is in direct contact with the metal layer ML. Accordingly, because the organic planarization layer 30 including an organic material is in direct contact with the metal layer ML including metal, the organic planarization layer 30 may not be easily detached from the display panel 10 by external impacts or the like. That is, defect occurrence possibility may be reduced during the process of manufacturing the display apparatus 1.

Although shown in FIG. 6, because forming of each of elements of the display apparatus 1 not described with reference to FIGS. 12 to 17 may be performed through the known photo process, detailed descriptions associated therewith are omitted. That is, because the forming of each element of the display apparatus 1 is general content in manufacturing the display apparatus, detailed description associated therewith is omitted.

In an embodiment, a display apparatus with a reduced defect occurrence possibility during a manufacturing process, and a method of manufacturing the display apparatus, may be implemented. However, the scope of the disclosure is not limited by this effect.

It should be understood that embodiments described herein should be considered in a descriptive sense only and not for purposes of limitation. Descriptions of features or advantages within each embodiment should typically be considered as available for other similar features or advantages in other embodiments. While embodiments have been described with reference to the drawing figures, it will be understood by those of ordinary skill in the art that various changes in form and details may be made therein without departing from the scope as defined by the following claims.

## Claims

1. A display apparatus (1) comprising:
a substrate (100) including a display area (DA) in which a display element (DPE) is disposed, and a peripheral area (PA) outside the display area (DA);
a dam portion (160) disposed in the peripheral area (PA) and surrounding the display area (DA);
a crack dam (190) disposed between the dam portion (160) and an edge (100E) of the substrate (100);
an organic planarization layer (30) disposed in the display area (DA) and the peripheral area (PA) and covering the display element (DPE), the dam portion (160), and the crack dam (190);
a metal layer (ML) disposed between the organic planarization layer (30) and the crack dam (190) and extending in a direction from the crack dam (190) to the edge (100E) of the substrate (100); and
an inorganic protective layer (IPL) disposed between the organic planarization layer (30) and the metal layer (ML) and covering a portion of the metal layer (ML),
wherein a portion of a part of the organic planarization layer (30) disposed between the crack dam (190) and the edge (100E) of the substrate (100) is in direct contact with the metal layer (ML).

2. The display apparatus (1) of claim 1, further comprising an inorganic insulating layer (430) covering the display element (DPE), the dam portion (160), and the crack dam (190),
wherein the metal layer (ML) is disposed on the inorganic insulating layer (430).

3. The display apparatus (1) of claim 2, wherein:
(i) the inorganic protective layer (IPL) is disposed on the metal layer (ML) to be spaced apart from the edge (100E) of the substrate (100); and/or
(ii) an end (PLE) of the inorganic protective layer (IPL) is disposed on the metal layer (ML).

4. The display apparatus (1) of claim 2 or claim 3, wherein the metal layer (ML) extends in a direction from the crack dam (190) to the dam portion (160),
the inorganic protective layer (IPL) includes a first inorganic protective layer (IPL1) and a second inorganic protective (IPL2) layer apart from each other,
the first inorganic protective layer (IPL1) covers a portion of the metal layer (ML) disposed on the dam portion (160),
the second inorganic protective layer (IPL2) covers a portion of the metal layer (ML) disposed on the crack dam (190), and
the second inorganic protective layer (IPL2) partially covers a portion of the metal layer (ML) disposed between the crack dam (190) and the edge (100E) of the substrate (100).

5. The display apparatus (1) of claim 4, wherein the inorganic protective layer (IPL) does not cover a portion of a part of the metal layer (ML) disposed between the dam portion (160) and the crack dam (190), optionally wherein a portion of a part of the organic planarization layer (30) disposed between the dam portion (160) and the crack dam (190) is in direct contact with the metal layer (ML).

6. The display apparatus (1) of claim 4 or claim 5, wherein the metal layer (ML) includes a first metal layer (ML1), a second metal layer (ML2), and a third metal layer (ML3) disposed between the first metal layer (ML1) and the second metal layer (ML2),
the first metal layer (ML1) covers a portion of the inorganic insulating layer (430) disposed on the dam portion (160),
the second metal layer (ML2) covers a portion of the inorganic insulating layer (430) disposed between the crack dam (190) and the edge (100E) of the substrate (100), the first inorganic protective layer (IPL1) covers the first metal layer (ML1), and the second inorganic protective layer (IPL2) covers the second metal layer (ML2).

7. The display apparatus (1) of any one of claims 2 to 6, wherein the inorganic protective layer (IPL) is partially disposed on a portion of the metal layer (ML) disposed between the crack dam (190) and the edge (100E) of the substrate (100).

8. The display apparatus (1) of claim 7, wherein:
(i) an end (PLE) of the inorganic protective layer (IPL) is disposed on a portion of the metal layer (ML) disposed between the crack dam (190) and the edge (100E) of the substrate (100); and/or
(ii) the inorganic protective layer (IPL) covers a portion of the metal layer (ML) next to the crack dam (190) and does not cover a portion of the metal layer (190) next to the edge (100E) of the substrate (100).

9. The display apparatus (1) of any one of claims 2 to 8, wherein the metal layer (ML) is partially disposed on a portion of the inorganic insulating layer (430) disposed between the crack dam (190) and the edge (100E) of the substrate (100).

10. The display apparatus (1) of claim 9, wherein:
(i) an end (MLE) of the metal layer (ML) is disposed on a portion of the inorganic insulating layer (430) disposed between the crack dam (190) and the edge (100E) of the substrate (100); and/or
(ii) the metal layer (ML) covers a portion of the inorganic insulating layer (430) next to the crack dam (190) and does not cover a portion of the inorganic insulating layer (430) next to the edge (100E) of the substrate (100); and/or
(iii) the organic planarization layer (30) covers an end (MLE) of the metal layer (ML).

11. The display apparatus (1) of any one of claims 1 to 10, further comprising:
an encapsulation layer (300) disposed in the display area (DA) and the peripheral area (PA) and sealing the display element (DPE); and
a touch sensor layer (400) disposed on the encapsulation layer (300) and including a touch conductive layer (CL1, CL2) and a touch insulating layer (410, 420) covering the touch conductive layer (CL1, CL2),
optionally wherein the metal layer (ML) includes a same material as a material of the touch conductive layer (CL1, CL2), and
the inorganic protective layer (IPL) includes a same material as a material of the touch insulating layer (410, 420).

12. A method of manufacturing a display apparatus (1), the method comprising:
preparing a mother board (M100) including a panel area (10A) and a margin area (MA), wherein the panel area (10A) includes a display area (DA) and a peripheral area (PA) outside the display area (DA), and the margin area (MA) surrounds the panel area (10A) entirely;
forming a display element (DPE) in the display area (DA), forming a dam portion (160) in the peripheral area (PA) next to the display area (DA), and forming a crack dam (190) in the peripheral area (PA) next to the margin area (MA);
forming an inorganic insulating layer (430) over the display area (DA) and the peripheral area (PA) so that the inorganic insulating layer (430) covers the display element (DPE), the dam portion (160), and the crack dam (190);
forming a metal layer (ML) on the inorganic insulating layer (430), the metal layer (ML) covering the crack dam (190) and extending in a direction from the crack dam (190) to a panel border (10B), which is a border between the panel area (10A) and the margin area (MA);
forming an inorganic protective layer (IPL) on the metal layer (ML) and covering a portion of the metal layer (ML);
forming an organic planarization layer (30) over the display area (DA) and the peripheral area (PA) so that the organic planarization layer (30) covers the inorganic protective layer (IPL); and
cutting the mother board (M100) along the panel border (10B),
wherein the forming the organic planarization layer (30) comprises forming the organic planarization layer (30) so that a portion of a part of the organic planarization layer (30) formed between the crack dam (190) and the panel border (10B) is in direct contact with the metal layer (ML).

13. The method of claim 12, wherein the forming the inorganic protective layer (IPL) comprises forming the inorganic protective layer (IPL) so that the inorganic protective layer (IPL) is spaced apart from the panel border (10B) and an end (PLE) of the inorganic protective layer (IPL) is disposed on the metal layer (ML).

14. The method of claim 12 or claim 13, wherein:
(i) the forming the inorganic insulating layer (430) comprises forming a margin inorganic insulating layer (M430) in the margin area (MA),
the forming the metal layer (ML) comprises forming a margin metal layer (MML) on the margin inorganic insulating layer (M430), and
the forming the organic planarization layer (30) comprises forming a margin organic planarization layer (M30) on the margin metal layer (MML),
wherein, in the cutting the mother board (M100), the margin inorganic insulating layer (M430), the margin metal layer (MML), and the margin organic planarization layer (M30) are removed; and/or
(ii) the forming the metal layer (ML) comprises forming a touch conductive layer (CL1) on the inorganic insulating layer (430) in the display area (DA), and
the forming the inorganic protective layer (IPL) comprises forming a touch insulating layer (410) covering the touch conductive layer (CL1).

15. An electronic apparatus (2) comprising:
a display apparatus (1) according to any one of claims 1 to 11; and
a housing (3) accommodating the display apparatus (1) and forming an exterior.
